(19) Europäisches Patentamt / European Patent Office / Office européen des brevets

(11) **EP 1 770 405 A1**

(12) **EUROPÄISCHE PATENTANMELDUNG**

(43) Veröffentlichungstag:
**04.04.2007 Patentblatt 2007/14**

(51) Int Cl.:
*G01R 19/25* (2006.01)     *G01R 23/20* (2006.01)

(21) Anmeldenummer: 06090173.3

(22) Anmeldetag: **20.09.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **30.09.2005 DE 102005047901**
            **30.09.2005 US 721969 P**

(71) Anmelder: **Schering Aktiengesellschaft**
**13353 Berlin (DE)**

(72) Erfinder:
• **Habath, Thomas**
  **10715 Berlin (DE)**
• **Brandalik, Reyk**
  **15518 Heinersdorf (DE)**

(74) Vertreter: **Gross, Felix et al**
**Patentanwälte**
**Maikowski & Ninnemann**
**Postfach 15 09 20**
**10671 Berlin (DE)**

(54) **Vorrichtung zur Identifiziering von Verbrauchern in einem elektrischen Netz und Verfahren zum Betreiben der Vorrichtung**

(57) Die Erfindung bezieht sich auf eine Vorrichtung zur Identifizierung von Verbrauchern in einem elektrischen Netz (1) mit zeitlich veränderlichen Strömen, und weist eine Messvorrichtung (3) zur Messung mindestens eines Stromsignals des elektrischen Netzes an mindestens einem Messpunkt, ein Speichermedium (5), in dem mindestens ein vorab bestimmtes Verbraucherspektrum gespeichert ist, ein Datenanalyseeinrichtung (6) und einer Ausgabevorrichtung (7) auf. Die Datenanalyseeinrichtung (6) wandelt dabei die gemessenen Stromsignale des elektrischen Netzes (1) in ein Netzsignal um, generiert automatisch ein Modell, in dem das Netzsignal mit mindestens einem in dem Speichermedium (5) vorab gespeicherten Verbrauchersignal mindestens eines Verbrauchers (2a, 2b) verknüpfbar ist, und analysiert automatisch das Modell zur Bestimmung mindestens einer Verbraucherverteilung im elektrischen Netz.

Die Erfindung bezieht sich darüber hinaus auf ein Verfahren zum Betreiben der Vorrichtung.

Mit der erfindungsgemäßen Vorrichtung und dem Verfahren ist es somit möglich, auf einfache und präzise Weise die Verbraucher und die Verbraucherverteilung in einem elektrischen Netz durch eine einzelne Messung zu identifizieren.

**FIG 1A**

EP 1 770 405 A1

**Beschreibung**

Die Erfindung betrifft eine Vorrichtung zur Identifizierung von Verbrauchern in einem elektrischen Netz und ein Verfahren zum Betreiben der Vorrichtung.

In einem elektrischen Netz, beispielsweise einem elektrischen Energieversorgungsnetz, in dem eine Vielzahl von Verbrauchern zu einem Netzwerk zusammengeschaltet sind, kann es durch den durch einen Verbraucher fließenden und durch den Verbraucher beeinflussten Strom zu Rückwirkungen auf die Versorgungsspannung kommen, die an einem Einspeisungspunkt an dem elektrischen Netz anliegt. Dieser Effekt wird im Allgemeinen als Netzrückwirkung bezeichnet und wird verursacht durch die direkte Beeinflussung des Stroms und der Spannung durch die Verbraucher in dem elektrischen Netz. Die durch die Verbraucher verursachten Netzrückwirkungen werden dabei durch die Art der Verbraucher in dem elektrischen Netz bestimmt.

Ein Effekt der Netzrückwirkungen ist, dass in einem elektrischen Netz, bei dem an einem Punkt eine Versorgungsspannung mit einer sinusförmigen Grundschwingung anliegt, der in den Zweigen des elektrischen Netzes fließende Strom keine reine Sinusform aufweist, also nicht durch eine Schwingung mit einer einzelnen Frequenz beschreibbar ist. In diesem Fall bildet der Strom im elektrischen Netz Oberschwingungen aus, die die Form von Strom und Spannung am Einspeisungspunkt, aber auch am Ort der Verbraucher nachteilig beeinflussen.

Oberschwingungen lassen sich prinzipiell in harmonische und zwischenharmonische Oberschwingungen einteilen. Harmonische Oberschwingungen (auch kurz als Harmonische bezeichnet) weisen Frequenzen auf, die ganzzahlige Vielfache der Grundfrequenz sind. Zwischenharmonische Oberschwingungen hingegen haben Frequenzen ungleich den ganzzahligen Vielfachen der Grundfrequenz. Harmonische Oberschwingungen können beispielsweise durch Verbraucher mit einer nicht-linearen Strom-Spannungs-Charakteristik, beispielsweise einer Diode, verursacht werden. Zwischenharmonische entstehen hingegen beispielsweise bei Schaltvorgängen, die nicht mit der Grundfrequenz der Spannung synchronisiert sind.

Oberschwingungen im Strom eines elektrischen Netzes bewirken Verzerrung des Stroms und können somit zu Problemen im elektrischen Netz, insbesondere für die mit dem elektrischen Netz verbundenen Verbraucher führen. Durch die nichtsinusförmige Stromaufnahme des Netzes entsteht an dem Einspeisungspunkt des Netzes ein nichtsinusförmiger Spannungsabfall, so dass die am Einspeisungspunkt anliegende Versorgungsspannung verzerrt wird und Oberschwingungen ausbildet. Solche Oberschwingungen werden von den Verbrauchern des Netzes wahrgenommen und können den Betrieb und die Lebensdauer der Verbraucher nachteilig beeinflussen. Problematisch ist dieses beispielsweise für Verbraucher, an deren Präzision hohe Anforderungen gestellt werden, beispielsweise Präzisionsmessgeräte, Medizinsystem oder dergleichen, die durch die Verzerrungen im der Energieversorgung dienenden elektrischen Netz in ihrer Funktion erheblich beeinträchtigt sind.

Die beschriebenen Probleme treten dabei insbesondere in als Energieversorgungsnetze ausgebildeten elektrischen Netzen auf. Die Bedeutung solcher Energieversorgungsnetze zur weltweiten Energieversorgung hat in den letzten Jahrzehnten enorm an Bedeutung gewonnen, wobei der Bedarf an elektrischer Energie stetig und überproportional zur Weltbevölkerung angestiegen ist. Die Art, Verteilung und Anzahl der Verbraucher in Energieversorgungsnetzen hat sich dabei in den letzten Jahren verändert und eine Verstärkung der Netzrückwirkungen, also der Verzerrung der Ströme und Spannungen in den Energieversorgungsnetzen bewirkt. Dies hat dazu geführt, dass in den letzten Jahren Grenzwerte für die Verzerrung in Energieversorgungsnetzen nicht eingehalten werden konnten, und die Wahrscheinlichkeit von Ausfällen von Verbrauchern, vor allem im industriellen Bereich, stetig gestiegen ist.

Um Vorhersagen über Verzerrungen von Strömen und Spannungen in einem elektrischen Netz treffen zu können, Netzrückwirkungen zu verringern oder zu kompensieren, ist es von Interesse, die Verbraucherverteilung in dem elektrischen Netz, also die prozentualen Anteile von unterschiedlichen Verbrauchern in dem elektrischen Netz, präzise zu bestimmen.

Aufgabe der vorliegenden Erfindung ist es, eine Vorrichtung und ein Verfahren zur Verfügung zu stellen, mit denen Verbraucher in einem elektrischen Netz, die Verzerrungen von Strömen und Spannungen in dem elektrischen Netz verursachen, auf präzise und einfache Weise identifiziert und / oder die Verbraucherverteilung im elektrischen Netz bestimmt werden können.

Diese Aufgabe wird erfindungsgemäß durch eine Vorrichtung mit den Merkmalen des Anspruchs 1 gelöst.

Erfindungsgemäß ist dabei vorgesehen, dass eine Vorrichtung zur Identifizierung von Verbrauchern in einem elektrischen Netz mit zeitlich veränderlichen Strömen,

- eine Messvorrichtung zur Messung mindestens eines Stromsignals an mindestens einem Messpunkt des elektrischen Netzes,
- ein Speichermedium, in dem mindestens ein vorab bestimmtes Verbrauchersignal gespeichert ist,
- eine Datenanalyseeinrichtung, die

  - das mindestens eine gemessene Stromsignale in ein Netzsignal umwandelt,

- automatisch ein Modell generiert, in dem das Netzsignale mit mindestens einem in dem Speichermedium vorab gespeicherten Verbrauchersignal mindestens eines Verbrauchers verknüpfbar ist,
- automatisch das Modell zur Bestimmung mindestens einer Verbraucherverteilung der Verbraucher im elektrischen Netz analysiert, und

- eine Ausgabevorrichtung für die mindestens eine Verbraucherverteilung, aufweist.

Die erfindungsgemäße Vorrichtung erlaubt die Bestimmung der Verbraucherverteilung der Verbraucher in dem elektrischen Netz allein aus erfassten und im Speichermedium gespeicherten Verbrauchersignalen und dem erfassten Netzsignal des elektrischen Netzes. Zur Erfassung des Netzsignals wird mittels der Messvorrichtung das Stromsignal des elektrischen Netzes an einem Messpunkt gemessen und von der Datenanalyseeinrichtung in das Netzsignal umgewandelt. Die Datenanalyseeinrichtung generiert aus dem erfassten Netzsignal und aus in einem Speichermedium gespeicherten Verbrauchersignalen ein Modell, in dem das Netzsignal mit den Verbrauchersignalen verknüpft ist und das zur Identifikation der Verbraucher, insbesondere der diskreten Verbraucherverteilung der Verbraucher m elektrischen Netz analysiert wird. Als Verbrauchersignal ist hier das Signal eines durch einen Verbraucher aufgenommenen Stroms bei alleiniger Betrachtung des Verbrauchers (ohne Einfluss der übrigen Verbraucher im elektrischen Netz) bezeichnet. Die Verbraucherverteilung gibt an, welche Verbraucher mit welchen Anteilen in dem elektrischen Netz vorhanden sind und ist, begründet durch die endliche Anzahl vorkommender Verbraucher, diskret.

Wesentlicher Vorteil der erfindungsgemäßen Vorrichtung ist, dass mittels der Vorrichtung die in einem elektrischen Netz angeordneten Verbraucher durch eine einfache Messung eines Stromsignals an einem Messpunkt des elektrischen Netzes bestimmt werden können.

Das durch die Messvorrichtung gemessene Stromsignal ist bevorzugt ein zeitliches Signal. Das Netzsignal, das aus dem Stromsignal abgeleitet wird, kann hingegen entweder ein zeitliches Signal oder ein ein Frequenzsignal darstellendes Netzspektrum sein. Das Verbrauchersignal kann wie das Netzsignal ebenfalls entweder ein zeitliches Signal oder ein ein Verbraucherspektrum darstellendes Frequenzsignal sein. Werden zeitliche Signale verwendet, so umfassen die Verbrauchersignale und das Netzsignal, die in dem Modell verknüpft sind, Abfolgen von Strommesswerten zu unterschiedlichen Zeitpunkten, die den Stromfluss durch die Verbraucher bzw. am Messpunkt des elektrischen Netzes charakterisieren. Werden Frequenzsignale, also Verbraucherspektren und ein Netzspektrum zur Generierung des Modells verwendet, so umfassen die Verbrauchersignale und das Netzsignal die Frequenzanteile des Stroms in den Verbrauchern bzw. am Messpunkt des elektrischen Netzes. Die Frequenzsignale und die zeitlichen Signale sind dabei über eine Fouriertransformation miteinander verknüpft.

Die Datenanalyseeinrichtung der Vorrichtung ist bevorzugt so ausgelegt, dass sie zur Identifizierung der Verbraucher in dem elektrischen Netz Mittel aufweist, mittels derer ein das Netzsignal darstellendes Netzspektrum aus einem gemessenen Stromsignal des elektrischen Netzes ermittelbar ist oder das Netzsignal im Zeitbereich durch geeignete Synchronisation und Normierung gebildet wird. Die Messung des Stromsignals erfolgt dabei im auszumessenden elektrischen Netz, stellt also die eigentliche, bei Bedarf beliebig oft wiederholbare Messung dar. Anhand des so bestimmten Netzspektrums oder des zeitlichen Netzsignals und unter Einbeziehung von vorab ermittelten und in einer Datenbank gespeicherten, Verbrauchersignale darstellenden Verbraucherspektren oder der zeitlichen Verbrauchersignale wird dann die Verbraucherverteilung der Verbraucher in dem elektrischen Netz bestimmt.

Ist das Stromsignal des elektrischen Netzes ein zeitliches Signal und sollen Frequenzsignale zur Generierung des Modells verwendet werden, so bestimmt die Datenanalyseeinrichtung das Netzspektrum durch eine Fouriertransformation aus dem gemessenen Stromsignal des elektrischen Netzes. Die Datenanalyseeinrichtung kann dabei insbesondere Mittel zur Durchführung einer FFT (Fast Fourier Transform) aufweisen, die eine effiziente Durchführung der Umwandlung vom Stromsignal in das Netzspektrum ermöglicht.

Die Datenanalysevorrichtung weist vorteilhafterweise Mittel zur Generierung des Modells auf, mittels derer das mindestens eine Verbraucherspektrum oder das zeitliche Verbrauchersignal und das Netzspektrum oder das zeitliche Netzsignal in einem Gleichungssystem verknüpfbar sind. In der Datenanalyseeinrichtung erfolgt somit eine Aufstellung eines Gleichungssystems, in das die im Speichermedium vorab gespeicherten Verbraucherspektren oder zeitlichen Verbrauchersignale und das gemessene Netzspektrum oder das zeitliche Netzsignal eingehen. Dieses Gleichungssystem wird analysiert und auf diese Weise die Verbraucherverteilung, also die prozentuale Verteilung der Verbraucher im elektrischen Netz, bestimmt.

Die Vorrichtung weist erfindungsgemäß ein Speichermedium auf, in dem die Verbrauchersignale unterschiedlicher Verbraucher gespeichert sind. Bevorzugt weist die Vorrichtung dabei eine weitere Messvorrichtung auf, mittels derer die Verbrauchersignale der Verbraucher vor der eigentlichen Messung erfasst und in dem Speichermedium in Form einer Datenbank gespeichert werden. Zu diesem Zweck ist die Messvorrichtung mit dem Speichermedium verbindbar und gleicht die erfassten Verbrauchersignale mit der Datenbank des Speichermediums ab. Diese Messvorrichtung dient somit der Erfassung von Verbrauchersignalen von Verbrauchern vor der eigentlichen Messung. Es ist dabei nicht erforderlich, dass die Verbraucher zur Erfassung der Verbrauchersignale in demselben elektrischen Netz, an dem die Erfassung des Netzsignals erfolgt, angeordnet sind. Denkbar ist, dass ein oder mehrere Verbraucher in einem oder mehreren separaten Netzen vor Beginn der eigentlichen Messung erfasst werden, die Verbrauchersignale der Verbraucher in der Datenbank gespeichert werden und die Verbraucherverteilung dieser erfassten Verbraucher dann in einem anderen elektrischen Netz bestimmt wird. Die Messvorrichtung zur Erfassung der Verbrauchersignale dient somit zur Generierung einer Datenbank, die in dem Speichermedium der Vorrichtung gespeichert wird. Die Messvorrichtung kann dabei als gesonderte Messvorrichtung ausgebildet sein, die ausschließlich der Erfassung der Verbrauchersignale dient. Es ist aber auch denkbar, zur Erfassung der Verbrauchersignale dieselbe Messvorrichtung wie zur späteren Erfassung der Netzsignale zu verwenden.

Vorteilhafterweise weist die Messvorrichtung zur Erfassung der Verbrauchersignale ein Mittel auf, mittels dessen das Stromsignal des mindestes einen Verbrauchers messbar und aus dem Stromsignal das Verbrauchersignal bestimmbar ist. Die Messvorrichtung bestimmt somit aus einem gemessenen Stromsignal eines Verbrauchers das Verbrauchersignal des Verbrauchers und leitet dieses an das Speichermedium weiter.

Die Messvorrichtung zur Erfassung eines oder mehrerer Verbrauchersignale kann dabei so beschaffen sein, dass sie ein zeitliches Stromsignal aufnimmt, dieses fouriertransformiert und somit aus dem gemessenen Stromsignal das Verbrauchersignal bestimmt.

Nach Erfassung eines Verbrauchersignals erfolgt ein Abgleich mit der in dem Speichermedium abgelegten Datenbank. Die Messvorrichtung zur Erfassung der Verbrauchersignale kann dabei Mittel aufweisen, mittels derer eine Einteilung der Verbraucher anhand der erfassten Verbrauchersignale in Verbraucherklassen erfolgt. Zu diesem Zweck wird jedes erfasste Verbrauchersignal mit anderen, in der Datenbank gespeicherten Verbrauchersignalen verglichen, wobei Verbraucher mit ähnlichen Verbrauchersignalen einer mehrere Verbraucher umfassenden Verbraucherklasse zugeordnet werden.

Es ist denkbar, dass die Messvorrichtung zur Erfassung der Verbrauchersignale ein mobiles Messgerät ist, das zum Abgleich mit der im Speichermedium gespeicherten Datenbank mit dem Speichermedium verbindbar ist, ansonsten aber separat von den übrigen Komponenten der Vorrichtung betrieben werden kann. Eine so ausgebildete Messvorrichtung ermöglicht einen flexiblen Einsatz und eine einfache Handhabung der Vorrichtung, insbesondere zur initialisierenden Erfassung verschiedener Verbrauchersignale.

In einer vorteilhaften Ausgestaltung ist die Vorrichtung zur Messung des Stromsignals des elektrischen Netzes an einen Messpunkt des elektrischen Netzes angeschlossen. Dabei ist es denkbar, dass die Vorrichtung fest mit dem elektrischen Netz verbunden ist und somit Bestandteil des Netzes ist. Dieses ist vorteilhaft, wenn eine langzeitige, wiederholte Identifizierung der Verbraucher in dem elektrischen Netz gewünscht ist.

In einer anderen Ausgestaltung ist die Vorrichtung in ein kompaktes Messgerät integriert, das stationär an einem elektrischen Netz angeordnet und mit diesem verbunden sein kann oder als mobiles Messgerät zur variablen Verwendung in unterschiedlichen elektrischen Netzen ausgelegt sein kann. Die Vorrichtung kann dabei insbesondere als Baustein, der die Verbraucherverteilung von Verbrauchern in einem elektrischen Netz bestimmt, einem bereits bestehenden Messgerät hinzugefügt werden und somit eine Erweiterung eines bestehenden Messgerätes darstellen.

In einer vorteilhaften Ausgestaltung der Erfindung weist die Vorrichtung eine Kompensationsvorrichtung auf, die zur Kompensation einer Verzerrung der Ströme und Spannungen in einem elektrischen Netz mit der Datenanalyseeinrichtung so zusammenwirkt, dass die Ströme und die Spannungen in dem elektrischen Netz in gewünschter Weise angepasst werden. Die Kompensationsvorrichtung ist dabei mit dem elektrischen Netz verbunden oder in das elektrische Netz integriert, bestimmt aus der von der Datenanalyseeinrichtung bestimmten Verbraucherverteilung Kompensationsparameter und wirkt so auf den Strom und die Spannung im elektrischen Netz ein, dass sich zumindest am Ort eines oder mehrerer Verbraucher ein gewünschter Strom oder eine gewünschte Spannung einstellt. Die Kompensationsvorrichtung stellt somit eine Rückkopplung zur Regelung des elektrischen Netzes dar: aus dem gemessenen Stromsignal wird das Netzsignal bestimmt, aus dem Netzsignal wird wiederum die Verbraucherverteilung hergeleitet, und aus der Verbraucherverteilung werden die zur Kompensation des Netzes erforderlichen Kompensationsparameter bestimmt, mit denen dann die Kompensationsvorrichtung eine Kompensation des elektrischen Netzes vornimmt.

Vielfältige Einsatzmöglichkeiten der erfindungsgemäßen Vorrichtung sind denkbar.

Beispielsweise kann die Vorrichtung zur Bestimmung der Verbraucher in einem Energieversorgungsnetz eingesetzt werden. Die Vorrichtung kann dann die Verbraucherverteilung von Verbrauchern in dem Energieversorgungsnetz bestimmen und abhängig von der Verbraucherverteilung der Verbraucher die Strom- und Spannungseinspeisung in das Energieversorgungsnetz variieren, so dass Verzerrungen im Strom und in der Spannung des Energieversorgungsnetzes reduziert und die Oberschwingungen im Energieversorgungsnetz kompensiert werden.

Denkbar ist auch, dass die Vorrichtung zur Überwachung und / oder Steuerung einer Anlage mit einem elektrische Netz und in dem elektrischen Netz angeordneten Verbrauchern dient. Die Vorrichtung kann dann anhand der ermittelten Verbraucherverteilung Funktionsstörungen in einzelnen oder mehreren der Verbraucher ermitteln und anzeigen, somit gesonderte Sensoren eines Sensorsystems zur Überwachung der Anlage ersetzen. Beispielsweise ist der Einsatz der Vorrichtung zur Überwachung einer elektrische Maschinen aufweisenden Produktionsanlage oder Produktionslinie oder eines elektrischen Industrienetzes, beispielsweise einer Fabrik oder dergleichen, denkbar. Die Vorrichtung ermittelt dann zu einem Zeitpunkt die Verbraucherverteilung der Anlage oder Produktionslinie. Werden Abweichungen zu einer als normal definierten Verbraucherverteilung festgestellt, so kann auf eine Funktionsstörung eines oder mehrerer der Verbraucher geschlossen werden und aus der Verbraucherverteilung gleichzeitig ermittelt werden, bei welchem Verbraucher diese Funktionsstörung vorhanden ist.

Die Aufgabe wird darüber hinaus durch ein Verfahren mit den Merkmalen des Anspruchs 19 gelöst. Erfindungsgemäß weist das Verfahren folgende Schritte auf:

- Messung mindestens eines Stromsignals eines elektrischen Netzes an mindestens einem Messpunkt,
- Bestimmung eines Netzsignals aus dem mindestens einen gemessenen Stromsignal des elektrischen Netzes,
- automatische Generierung eines Modells, in dem das Netzsignal und mindestens ein vorab erfasstes Verbrauchersignal mindestens eines Verbrauchers miteinander verknüpft sind,
- automatische Analyse des Modells zur Identifizierung der Verbraucher im elektrischen Netz,
- Speicherung und / oder Ausgabe einer diskreten Verbraucherverteilung im elektrischen Netz.

Mit dem erfindungsgemäßen Verfahren zum Betreiben der Vorrichtung nach einem der Ansprüche 1 bis 18 wird zunächst das Stromsignal eines elektrischen Netzes an einem Messpunkt gemessen. Anschließend wird das Stromsignal in das Netzsignal umgewandelt, wobei bei einem zeitlichen Stromsignal und einem als Netzspektrum ausgebildeten Netzsignal die Umwandlung mittels einer Fouriertransformation erfolgt. Aus dem so erfassten Netzsignal und den in einer Datenbank eines Speichermediums gespeicherten Verbrauchersignalen wird dann ein Modell generiert, in dem das Netzsignal mit den Verbrauchersignalen verknüpft wird und das zur Ermittlung der Verbraucherverteilung analysiert wird. In einem letzten Schritt wird die Verbraucherverteilung dann gespeichert oder mittels einer Ausgabevorrichtung ausgegeben.

Mittels des erfindungsgemäßen Verfahrens ist somit die Bestimmung der Verbraucherverteilung der Verbraucher in dem elektrischen Netz auf einfache und präzise Weise möglich, wobei die Messung des Netzsignals an einem Messpunkt des elektrischen Netzes ausreicht, um die Verbraucher in dem elektrischen Netz zu bestimmen.

Die Verbrauchersignale der Verbraucher werden vorteilhafterweise als diskrete Vektoren dargestellt, die zur Generierung des Modells in einer Verbrauchermatrix angeordnet werden. Aus dem gemessenen Netzsignal, das ebenfalls einen Vektor darstellt, und der Verbrauchermatrix wird dann ein Gleichungssystem gebildet, welches zur Identifikation der Verbraucher im elektrischen Netz analysiert wird und aus dem die Verbraucherverteilung ermittelt wird. Die Vektoren des Netzsignals und der Verbrauchersignale umfassen, abhängig davon, ob das Netzsignal und die Verbrauchersignale zeitliche Signale oder Frequenzsignale sind, die Stromwerte an dem Messpunkt des elektrischen Netzes bzw. an den Verbrauchern zu diskreten Zeitpunkten oder die Stromamplituden bei diskreten Frequenzen.

Bevorzugt werden vorab, also vor Beginn des regulären Messbetriebs, in einer Initialisierungsphase die Verbrauchersignale eines Verbrauchers oder mehrerer Verbraucher erfasst und in einem Speichermedium in Form einer Datenbank gespeichert. Die Verbrauchersignale müssen dabei nur einmal erfasst werden. Sind in der Datenbank die relevanten Verbraucher erfasst, so erübrigen sich weitere Messungen zur Bestimmung weiterer Verbrauchersignale.

Verschiedene Verfahren zur Erfassung der Verbraucherspektren sind denkbar.

Zum einem kann zur Bestimmung des Verbrauchersignals eines Verbrauchers das Stromsignal des Verbrauchers vorab gesondert gemessen werden, wobei der Verbraucher, um eine störungsfreie, exakte Messung zu gewährleisten, in möglichst isolierter Umgebung betrachtet werden sollte. Diese Erfassung ist, wie vorangehend ausgeführt, für jeden Verbraucher nur einmalig erforderlich.

Zum zweiten ist es möglich und vorteilhaft, zur Erfassung der Verbrauchersignale unterschiedliche Netzsignale zu unterschiedlichen Zeitpunkten zu erfassen und aus diesen unterschiedlichen, erfassten Netzsignalen die Verbrauchersignale abzuleiten. Dieses hat den Vorteil, dass keine gesonderte Messung der einzelnen Verbraucher in isolierter Umgebung notwendig ist, sondern die Verbrauchersignale in verschalteter Anordnung der Verbraucher im elektrischen Netz bestimmt werden können. Insbesondere ist es somit auch möglich, einen ständigen Abgleich und eine Aktualisierung der Datenbank der im Speichermedium gespeicherten Verbrauchersignale anhand der Netzsignale auch während der eigentlichen Messung in einem elektrischen Netz durchzuführen.

In letztgenanntem Fall erfolgt die Bestimmung der Verbrauchersignale aus den zu unterschiedlichen Zeitpunkten gemessenen Netzsignalen bevorzugt mittels einer Eigenwertanalyse oder einer Singulärwertzerlegung, indem die Netzsignale in einer Matrix angeordnet und analysiert werden.

Bevorzugt wird die Erfassung der Verbrauchersignale wiederholt durchgeführt und die Datenbank des Speichermediums beständig aktualisiert und angepasst.

Bei der Generierung der Datenbank kann es vorteilhaft sein, Verbraucher mit ähnlichen Verbrauchersignalen einer einzelnen Verbraucherklasse zuzuordnen, wobei sich das Verbrauchersignal der Verbraucherklasse aus den Verbrauchersignalen der in der Verbraucherklasse zusammengefassten Verbraucher ergibt. Dieses hat den Vorteil, dass zum einen die Generierung des Modells zur Identifizierung der Verbraucher in dem elektrischen Netz vereinfacht und zum anderen die Verbraucherverteilung präziser ermittelbar ist. Die Einteilung der Verbraucher in Verbraucherklassen ist darüber hinaus auch physikalisch sinnvoll, da Verbraucher mit ähnlichen Verbrauchersignalen auch ähnliche Rückwirkungen auf das elektrische Netz ausüben.

Die Ähnlichkeit zweier Verbrauchersignale bestimmt sich dabei über die Korrelation der Verbrauchersignale. Es ist zweckmäßig, Verbrauchersignale mit einem normierten Korrelationskoeffizienten größer als 0.9, insbesondere größer als 0.95 als ähnlich einzuordnen und einer gemeinsamen Verbraucherklasse zuzuordnen.

Bevorzugt erfolgt die Einteilung der Verbraucher in Verbraucherklassen automatisch, iterativ und adaptiv, so dass sich die Verbraucherklassen mit wiederholtem Abgleich der Datenbank ändern, die Einteilung in Verbraucherklassen mit jedem Abgleich neu evaluiert und die Datenbank durch zeitlich gestaffelte Messungen angepasst wird.

Vorteilhafterweise stellen die Verbrauchersignale der Verbraucher Verbraucherspektren und das Netzsignal des elektrischen Netzes ein Netzspektrum dar, wobei in den Verbraucherspektren und im Netzspektrum die Amplituden der harmonischen Oberschwingen der Stromsignale der Verbraucher bzw. des elektrischen Netzes gespeichert sind. Es ergeben sich somit diskrete Vektoren als Repräsentation der Verbraucherspektren und des Netzspektrums.

Vorteilhafterweise werden dabei ausschließlich die ungeraden harmonischen Oberschwingungen der Stromsignale der Verbraucher und des elektrischen Netzes in dem Modell berücksichtigt. Dieses ermöglicht eine Generierung des Modells bei minimalem Speicherbedarf und erlaubt eine effiziente Analyse des Modells.

Abhängig von der Anzahl der Verbraucher und der Anzahl der in den Verbraucherspektren und dem Netzspektrum erfassten harmonischen Oberschwingungen kann sich dabei ein unterbestimmtes, ein bestimmtes oder ein überbestimmtes Gleichungssystem ergeben. Die Lösung des Gleichungssystems entspricht dann der gesuchten Verbraucherverteilung der Verbraucher im elektrischen Netz.

Anhand der in den folgenden Figuren dargestellten Ausführungsbeispiele soll der der Erfindung zugrund liegende Gedanke näher und weiter erläutert werden. Es zeigen:

Figur 1A,B,C   schematische Ansichten von Vorrichtungen zur Identifikation von Verbrauchern in einem elektrischen Netz;

Figur 1D   Ablaufdiagramm eines Verfahrens zur Identifizierung einer Verbraucherverteilung von Verbrauchern in einem elektrischen Netz;

Figur 2   ein Diagramm des Spannungs- und Stromverlaufs an einer T5 Leuchtstoffröhre mit elektronischem Vorschaltgerät (EVG);

Figur 3   ein Diagramm des Spannungs- und Stromverlaufs einer Energiesparlampe;

Figur 4A, B   das das Verbrauchersignal darstellende Verbraucherspektrum (Betrag und Phase) einer T5 Leuchtstoffröhre mit elektronischem Vorschaltgerät (EVG);

Figur 5A, B   das das Verbrauchersignal darstellende Verbraucherspektrum (Betrag und Phase) einer Energiesparlampe;

Figur 6   eine schematische Detailansicht der Vorrichtung zur Identifikation von Verbrauchern in einem elektrischem Netz;

Figur 7   eine schematische Darstellung der Projektion des Netzspektrums $b$ auf die Verbrauchermatrix $A$;

Figur 8   ein schematisches Ablaufdiagramm der Fouriersynthese zur Überprüfung der bestimmten Verbraucherverteilung;

Figur 9   ein Diagramm einer ersten errechneten Verbraucherverteilung gemäß unterschiedlicher Lösungsansätze;

Figur 10   Diagramm eines erfassten Netzspektrums;

Figur 11   ein Diagramm einer zweiten errechneten Verbraucherverteilung gemäß der unterschiedlichen Lösungsansätze;

Figur 12   ein Diagramm des gemessenen Stromsignals eines elektrischen Netzes und des mittels Fouriersynthese aus der ermittelten Verbraucherverteilung bestimmten Stromsignals und

Figur 13        ein Diagramm, das gemessene *THD(I)*-Werte von acht unterschiedlichen Verbrauchern zeigt.

**1 Vorrichtung**

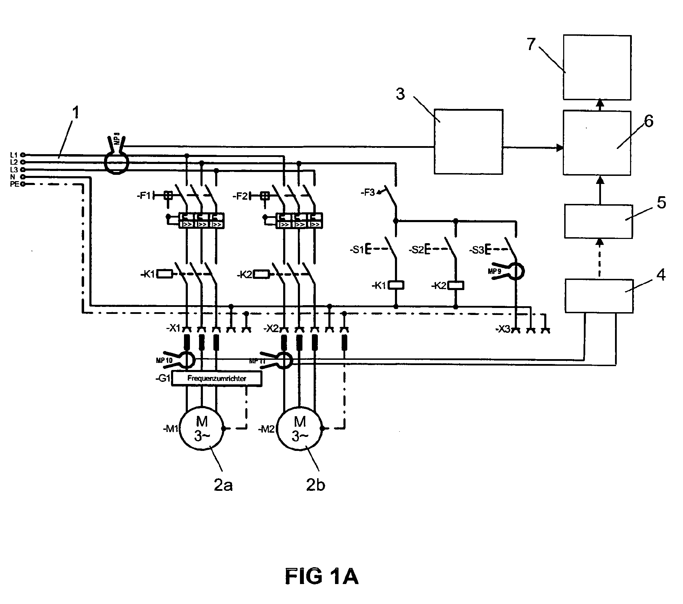

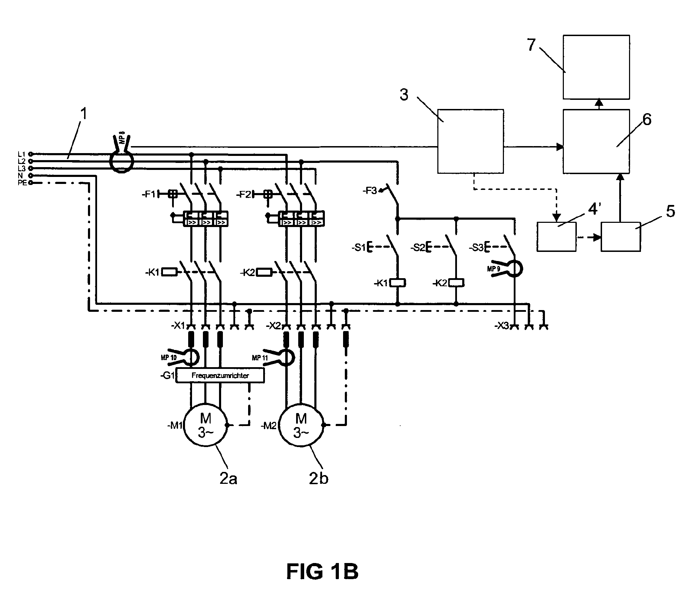

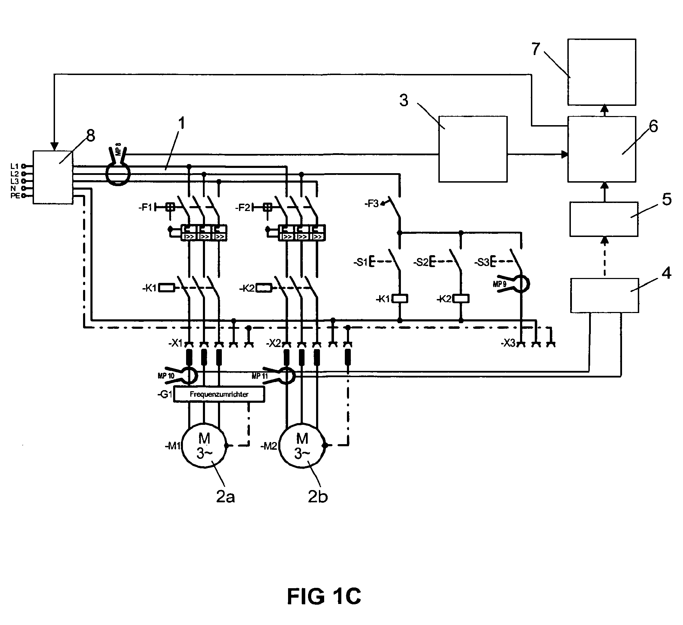

In den Figuren 1A, 1B und 1C sind unterschiedliche Ausgestaltungen der erfindungsgemäßen Vorrichtung dargestellt. Die erfindungsgemäßen Vorrichtungen weisen eine Messvorrichtung 3, ein Speichermedium 5, eine Datenanalyseeinrichtung 6 und eine Ausgabevorrichtung 7 auf. Die Messeinrichtung 3 ist über einen Messpunkt MP 8 mit dem elektrischen Netz 1 verbunden, das Netzleitungen L1, L2, L3 aufweist, über die elektrische Energie in das Netz eingespeist und Verbrauchern 2a, 2b zugeführt wird. Weitere Komponenten des elektrischen Netzes sind Schalter S1, S2, S3, Steuereinrichtungen K1, K2 und Sicherungen F1, F2.

Der erfindungsgemäße Gedanke ist hier anhand von Vorrichtung umgesetzt, bei denen aus erfassten, Netzsignale und Verbrauchersignale darstellenden Netzspektren bzw. Verbraucherspektren die Verbraucherverteilung von Verbrauchern in einem elektrischen Netz bestimmt wird. Die Netzspektren und den Verbraucherspektren repräsentieren dabei die Frequenzanteile der Ströme an einem Messpunkt des elektrischen Netzes bzw. an den Verbrauchern. In ähnlicher Weise könnten aber anstelle dieser Frequenzsignale zeitliche Signale, also zeitliche Netzsignale und Verbrauchersignale verwendet werden, die Stromwerte zu unterschiedlichen Zeitpunkten an dem Messpunkt des elektrischen Netzes bzw. an den Verbrauchern umfassen und somit das elektrische Netz bzw. die Verbraucher charakterisieren. Die zeitlichen Signale sind über eine Fouriertransformation mit den Frequenzsignalen verbunden und beinhalten dieselben Informationen wie die Frequenzsignale.

In einer ersten Ausgestaltung der Erfindung gemäß Figur 1A weist die Vorrichtung eine Messvorrichtung 4 auf, die über Messpunkte MP10, MP11 mit Verbrauchern 2a, 2b verbunden ist und zur Erfassung von Verbrauchersignale darstellenden Verbraucherspektren in einer initialisierenden Vorabmessung zur Generierung einer Datenbank dient.

Zur Identifizierung der Verbraucher in dem elektrischen Netz werden zunächst mittels der Messvorrichtung 4 die Verbraucherspektren von einem oder mehreren Verbrauchern 2a, 2b bestimmt und in einer Datenbank in dem Speichermedium 5 abgelegt. Diese Messung erfolgt nur einmalig vor Beginn der eigentlichen Messung und dient zur Generierung der Datenbank und Erfassung der zu identifizierenden Verbraucher 2a, 2b. Es ist dabei nicht erforderlich, dass die Verbraucher 2a, 2b zur Erfassung der Verbraucherspektren mit dem auszumessenden elektrischen Netz 1 verschaltet sind, also im eigentlichen elektrischen Netz 1 angeordnet sind. Vielmehr ist es vorteilhaft, die Verbraucher 2a, 2b vorab in einer isolierten Umgebung einzeln zu erfassen und so die Verbraucherspektren zu ermitteln.

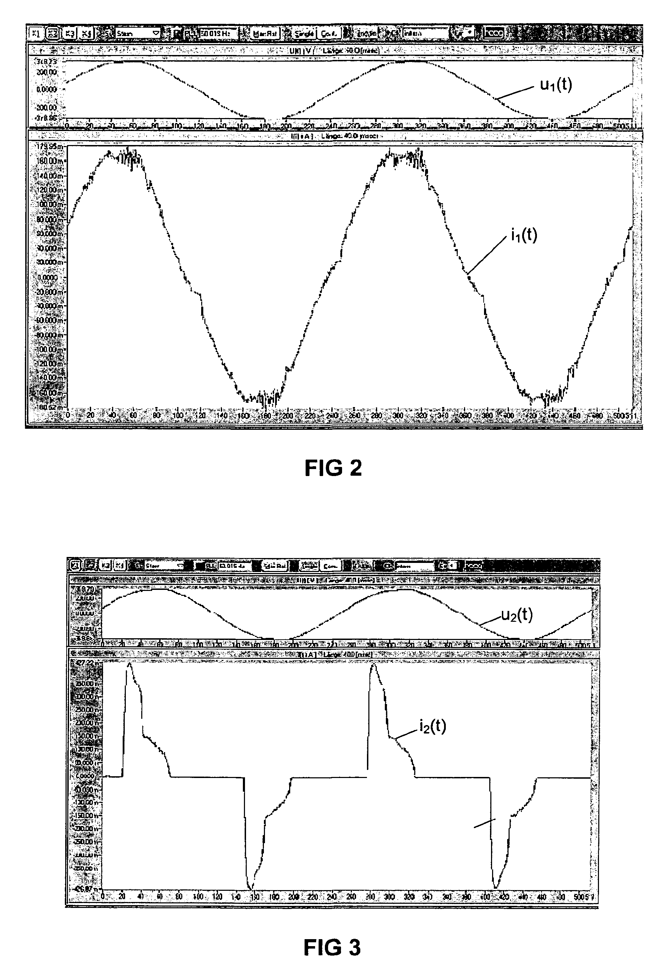

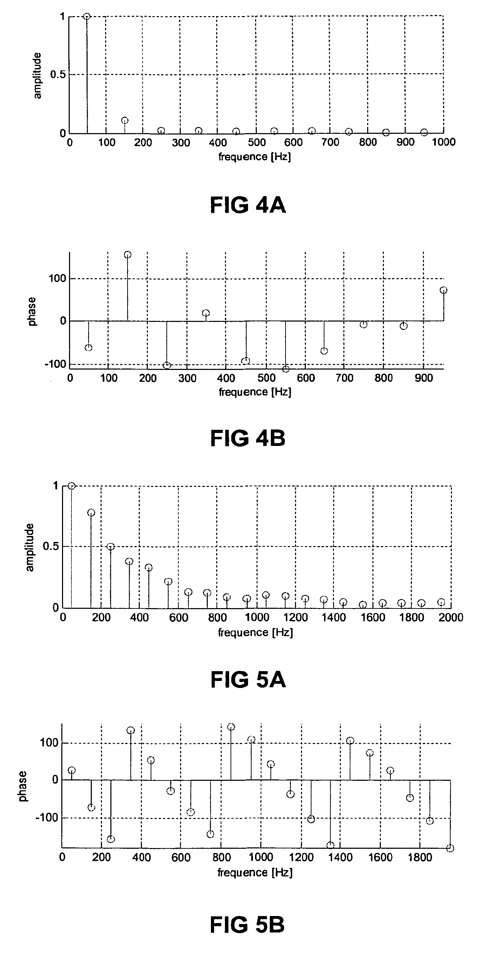

Die Figuren 2 und 3 zeigen zwei beispielhafte, gemessene Stromsignale $i_1(t)$, $i_2(t)$ zweier unterschiedlicher Verbraucher (eine Leuchtstoffröhre mit elektronischem Vorschaltgerät (EVG) in Figur 2 und eine Energiesparlampe in Figur 3), die die Antwort der Verbraucher auf Anregung durch eine sinusförmige Spannung $u_1(t)$, $u_2(t)$ beschreiben. Aus diesen mittels der Messeinrichtung gemessenen Stromsignalen der einzelnen Verbraucher bestimmt die Messeinrichtung 4 mittels einer Fouriertransformation die Verbraucherspektren. Die Verbraucherspektren der Leuchtstoffröhre mit elektronischem Vorschaltgerät (EVG) und der Energiesparlampe sind in den Figuren 4A,B bzw. 5A,B dargestellt, wobei die komplexen Verbraucherspektren jeweils Betrag und Phase aufweisen, die in einem Balkendiagramm dargestellt sind. In jedem Verbraucherspektrum sind dabei diskrete Oberschwingungen erfasst. Der äußerst linke Balken repräsentiert jeweils die Amplitude bzw. die Phase der Grundschwingung, während der äußerst rechts angeordnete Balken die Amplitude bzw. Phase der 10. Harmonischen angibt. In den dargestellten Verbraucherspektren sind zur Minimierung des Speicherplatzbedarfs und des Rechenaufwandes ausschließlich die Amplituden und Phasen der ungeraden Oberschwingungen in den Verbraucherspektren gemäß der Figuren 4A,B und 5A,B abgelegt und werden in dem Speichermedium 5 in einer Datenbank gespeichert.

In Figur 1B ist eine weitere Ausgestaltung der Vorrichtung dargestellt, die sich von der Vorrichtung gemäß Figur 1A in den Mitteln zur Erfassung der Verbraucherspektren unterscheidet. In der Vorrichtung gemäß der Figur 1 B erfolgt die Erfassung der Verbraucherspektren vorab mittels der Messung von Stromsignalen am Messpunkt MP8, die von der Analyseeinrichtung 4' in Netzsignale darstellende Netzspektren umgewandelt und in einer Matrix gespeichert werden. Die Analyseeinrichtung bestimmt aus den erfassten, unterschiedlichen und in einer Matrix angeordneten Netzspektren dann die Verbraucherspektren der Verbraucher 2a, 2b im elektrischen Netz 1 und speichert diese im Speichermedium 5. Die Bestimmung der Verbraucherspektren aus den erfassten Netzspektren kann dabei in der Analyseeinrichtung 4' mittels einer Eigenwertanalyse erfolgen, wobei die Eigenvektoren die einzelnen Verbraucherspektren darstellen. Vorteil dieser Ausgestaltung ist, dass die Verbraucher 2a, 2b nicht in einer isolierten Umgebung gesondert betrachtet werden müssen und ein ständiger Abgleich der Datenbank auch während der eigentlichen Messung erfolgen kann.

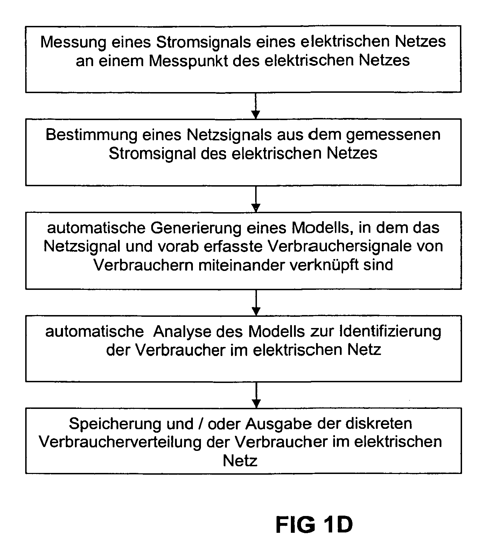

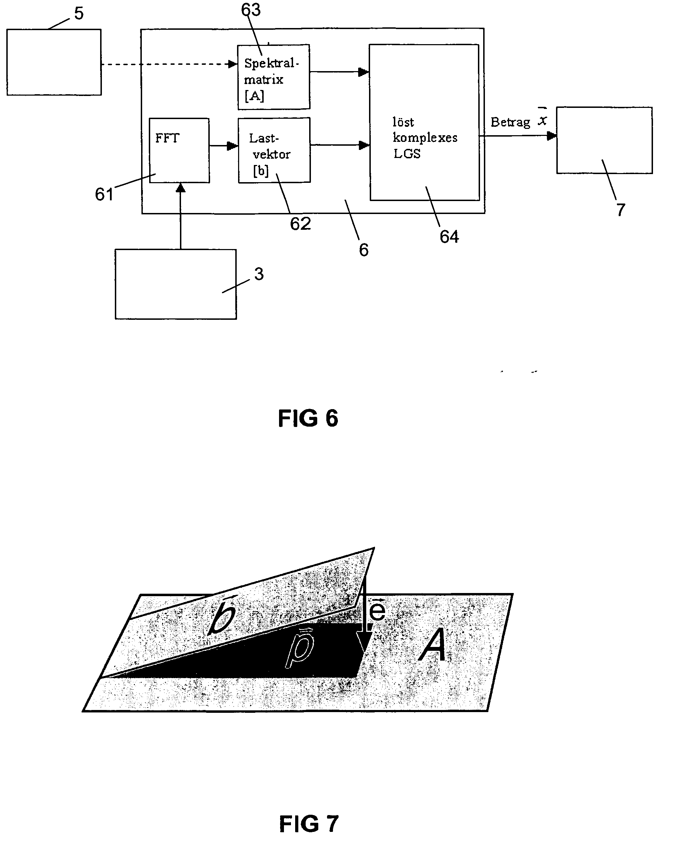

In beiden Ausgestaltungen der Vorrichtung gemäß der Figuren 1A und 1B ist der Ablauf der eigentlichen Messung zur Identifizierung der Verbraucher 2a, 2b in dem elektrischen Netz 1 gleich. Figur 6 zeigt in einer Detailansicht den in der Datenanalyseeinrichtung erfolgenden Ablauf zur Identifizierung der Verbraucher in dem elektrischen Netz. Die Messeinrichtung 3 misst das Stromsignal am Messpunkt MP8 des elektrischen Netzes 1. Die Datenanalyseeinrichtung 6 wandelt das durch die Messeinrichtung 3 gemessene Stromsignal in einem Baustein 61, der ein Mittel zur Durchführung einer Fouriertransformation darstellt, mittels einer Fouriertransformation in das das Netzsignal darstellende Netzspektrum um. Die Datenanalyseeinrichtung 6 weist weiterhin Mittel 62, 63, 64 auf, die aus dem Netzspektrum und den in der Datenbank des Speichermediums 5 abgelegten Verbraucherspektren das Modell generieren, wobei das Netzspektrum einen Lastvektor darstellt und zusammen mit den in der Verbrauchermatrix *A* angeordneten Verbraucherspektren ein lineares Gleichungssystem bildet. Die Mittel 62, 63 stellen dabei Bausteine dar, in denen die Verbrauchermatrix und das Netzspektrum zwischengespeichert werden. In dem Baustein 64 löst die Datenanalyseeinrichtung 6 das Gleichungssystem und ermittelt so die Verbraucherverteilung, die als Vektor x an die Ausgabevorrichtung 7 weitergeleitet wird. Der grundlegende Ablauf des Verfahrens, das durch die Vorrichtung zur Identifizierung der Verbraucher in einem elektrischen Netz ausführt, ist in Figur 1 D schematisch veranschaulicht.

Die Datenanalyseeinrichtung kann vorteilhafterweise durch eine Rechnereinrichtung ausgebildet sein. Die einzelnen Bausteine 61, 62, 63, 64 sind dann in der Rechnereinrichtung implementiert, und das Verfahren ist beispielsweise als Software unter Verwendung der Komponenten der Rechnereinrichtung realisiert. Als Software zur Implementierung des Verfahrens zur Identifizierung der Verbraucher in einem elektrischen Netz bieten sich dann bekannte Programme, beispielsweise das Programm Matlab (The Mathworks, USA) an.

Figur 1C zeigt eine dritte Ausgestaltung der Vorrichtung, die im Wesentlichen dieselben Komponenten wie die Vorrichtung gemäß der Figur 1A aufweist, in die aber zusätzlich eine Kompensationsvorrichtung 8 integriert ist, die zwischengeschaltet im elektrischen Netz 1 angeordnet ist. Die Kompensationsvorrichtung 7 ist mit der Datenanalyseeinrichtung 6 verbunden und erhält von der Datenanalyseeinrichtung 6 die ermittelte Verbraucherverteilung in Form eines Vektors *x*. Die Kompensationsvorrichtung bestimmt anhand des Vektors *x* Kompensationsparameter, mittels derer die Ströme und Spannungen im elektrischen Netz auf gewünschte Weise angepasst werden. Beispielsweise kann die Kompensationsvorrichtung nicht-lineare aktive oder passive Bauelemente enthalten, die mittels der Kompensationsparameter eingestellt und konfiguriert werden.

**2 Modell**

Im Folgenden werden die Generierung und die Analyse des Modells detailliert erläutert. Das Modell wird dabei im Folgenden anhand von Frequenzsignalen, also einem das Netzsignal darstellenden Netzspektrum und Verbrauchersignale darstellenden Verbraucherspektren beschrieben.

Quellen der Oberschwingungen sind Verbraucher mit einer nichtsinusförmigen, ein Stromsignal darstellenden Stromaufnahme, also alle Verbraucher mit Bauelementen mit nichtlinearer Strom-Spannungscharakteristik wie Eisendrosseln oder Halbleiterbauelemente. Diese kommen beispielsweise in Stromrichteranlagen für Antriebe, in Erwärmungsanlagen oder Schaltnetzteilen von heimelektronischen Geräten, z. B. Fernsehgeräte oder Computer, vor. Verbraucher mit unsymmetrischer und stark schwankender Phasenbelastung, wie z.B. Lichtbogenöfen und Schweißmaschinen, sind ebenfalls Verursacher von Oberschwingungen.

In einem elektrischen Netz können eine Vielzahl von unterschiedlichen Verbrauchern, beispielsweise PCs, computergesteuerte Laborgeräte, Beleuchtungsanlagen mit teilweise dimmbaren Leuchtstofflampen oder durch Frequenzumrichter drehzahlgesteuerte Antriebe, angeordnet sein. Letztere kommen in Lüftungsanlagen, Transportbandanlagen und in der Verfahrenstechnik, z.B. bei Rührwerksantrieben und Durchflussregelungen vor. Oftmals ist das elektrische Netz auch vorbelastet, so dass die an dem elektrischen Netz anliegende Spannung bereits verzerrt ist und zusätzlich Oberschwingungen in dem Stromsignal entstehen.

Prinzipiell lassen sich zwei Typen von Verbrauchern unterscheiden, nämlich lineare und nichtlineare Verbraucher.

**Lineare Verbraucher** Diese Verbraucher weisen ein ohmsches, induktives und/oder kapazitives Verhalten mit einem sinusförmigen Stromsignal auf und erzeugen keine Oberschwingungen.

**Nichtlineare Verbraucher** Bei einem Verbraucher mit einem prinzipiell sinusförmigen Stromsignal, der aber in irgendeiner Form geschaltet wird, so dass das Stromsignal des Verbrauchers periodisch oder nichtperiodisch in ihrer Amplitude manipuliert ist, entstehen Oberschwingungen, die zum einen harmonisch oder - bei Manipulation des Stromverlaufs durch den Verbraucher in nicht-synchroner Weise zur Grundschwingung - zwischenharmonisch ausgeprägt sein können. Typische Verbraucher, die zwischenharmonische Oberschwingungen erzeugen, sind Stromrichter, Direktumrichter oder Schwingungspaketsteuerungen. Durch zwischenharmonische Oberschwingungen können vor allem Signaleinrichtungen wie Rundsteueranlagen gestört und sogar Flicker ausgelöst werden.

**2.1 Theoretische Überlegungen zur Überlagerungen von harmonischen Oberschwingungen**

In einem elektrischen Netz tragen Verbraucher bzw. mehrer Verbraucher umfassende Verbraucherklassen in unterschiedlicher Weise zur Verzerrung des Stromsignals des elektrischen Netzes bei. Das Stromsignal bestimmt sich dabei durch Überlagerung der Stromsignale der einzelnen Verbraucher:

$$I_n = \sum_{i=2}^{m} I_{n,i} * e^{j\varphi_{n,i}} \qquad\qquad (2\text{-}1)$$

wobei $m$ die Anzahl der Verbraucher und $n$ die betrachtete Oberschwingung angibt.

Aus Gleichung 2-1 folgt, dass die Oberschwingungsbeiträge der einzelnen Verbraucher sich sowohl destruktiv als auch konstruktiv überlagern können. Eine destruktive Überlagerung erfolgt bei Gegenphasigkeit der Oberschwingungsbeiträge und eine konstruktive Überlagerung bei Gleichphasigkeit der Oberschwingungsbeiträge. Die Überlagerung ist außerdem abhängig vom Ort des Messpunktes im elektrischen Netz. Dabei ist die Phasenlage der gemessenen Signale am Ort der Messung entscheidend und kann durchaus verschieden von der Phasenlage am Ort des Verbrauchers sein. Die Verzerrung des Stromsignals eines elektrischen Netzes wird in der Regel durch den Klirrfaktor angegeben, der sich ergibt zu:

$$k_{gesamt} = \sqrt{\sum_{n=1}^{m} k^2{}_n} \qquad\qquad (2\text{-}2)$$

wobei $k_n$ den Klirrfaktor des $n$-ten Verbrauchers und $k_{gesamt}$ den Klirrfaktor des elektrischen Netzes am Messpunkt bezeichnet.

**2.2 Modellierung durch komplexe Frequenzvektorlinearkombination**

In einem elektrischen Netz mit parallel geschalteten Verbrauchern und vorerst vernachlässigter räumlicher Ausdehnung addieren sich die Ströme im Hauptzweig. Die periodischen Ströme können dabei vollständig durch ihre Fouriertransformierten beschrieben werden. Aufgrund der Linearitätseigenschaft der Fouriertransformierten

$$F(f_1(t) + f_2(t) + ... + f_n(t))(j\omega) = F_1(j\omega) + F_2(j\omega) + ... + F_n(j\omega) \qquad\qquad (2\text{-}3)$$

kann von einer linearen Überlagerung der Verbraucherspektren der einzelnen Verbraucher ausgegangen werden. Dabei kann die große Anzahl unterschiedlicher Verbraucher in eine überschaubare Anzahl $n$ von Verbraucherklassen eingeteilt werden, wobei die Verbraucher einer Verbraucherklasse ein ähnliches Verbraucherspektrum aufweisen und eine Verbraucherklasse durch ein einziges Verbraucherspektrum charakterisiert ist.

Das Verbraucherspektrum eines Verbrauchers (oder einer Verbraucherklasse) j liegt als Spaltenvektor vor:

$$\vec{F}_j = \begin{pmatrix} \overline{a}_{1j} \\ \overline{a}_{2j} \\ . \\ . \\ \overline{a}_{mj} \end{pmatrix}, \qquad\qquad (2\text{-}4)$$

wobei $\alpha_{ij}$ die komplexe Amplitude der i-ten betrachteten Harmonischen des $j$-ten Verbrauchers ist. An einem Verknüpfungspunkt überlagern sich die Ströme der Verbraucher, und somit ergibt sich aufgrund der Linearität der Fouriertransformierten das Netzspektrum $b$:

$$\begin{pmatrix} \overline{a}_{11} \\ \overline{a}_{21} \\ . \\ . \\ . \\ . \\ \overline{a}_{m1} \end{pmatrix} + \begin{pmatrix} \overline{a}_{12} \\ \overline{a}_{22} \\ . \\ . \\ . \\ . \\ \overline{a}_{m2} \end{pmatrix} + ... + \begin{pmatrix} \overline{a}_{1n} \\ \overline{a}_{2n} \\ . \\ . \\ . \\ . \\ \overline{a}_{mn} \end{pmatrix} = \begin{pmatrix} b_{1abs} \\ b_{2abs} \\ . \\ . \\ . \\ . \\ b_{mabs} \end{pmatrix} = \begin{pmatrix} \sum_{j=1}^{n} \overline{a}_{1j} \\ \sum_{j=1}^{n} \overline{a}_{2j} \\ . \\ \sum_{j=1}^{n} \overline{a}_{mj} \end{pmatrix} \qquad (2\text{-}5)$$

**Normierung** Setzt man statt dem gemessenen absoluten Verbraucherspektrum jedes Verbrauchers das auf die Grundschwingung normierte Verbraucherspektrum,

$$\vec{F}_{j\_norm} = \frac{1}{|\overline{a}_{1j}|} \begin{pmatrix} \overline{a}_{1j} \\ \overline{a}_{2j} \\ . \\ . \\ \overline{a}_{mj} \end{pmatrix} = \begin{pmatrix} a_{1j} \\ a_{2j} \\ . \\ . \\ a_{mj} \end{pmatrix} \qquad (2\text{-}6)$$

ein, so kann man von dem spezifischen Verbraucherspektrum bzw. Frequenzvektor sprechen. Setzt man dieses in Gleichung 2-5 ein, so erhält man das folgende lineare Gleichungssystem.

$$x_1 \begin{pmatrix} a_{11} \\ a_{21} \\ . \\ . \\ a_{m1} \end{pmatrix} + x_2 \begin{pmatrix} a_{12} \\ a_{22} \\ . \\ . \\ a_{m2} \end{pmatrix} + ... + x_n \begin{pmatrix} a_{1n} \\ a_{2n} \\ . \\ . \\ a_{mn} \end{pmatrix} = \begin{pmatrix} b_{1abs} \\ b_{2abs} \\ . \\ . \\ b_{mabs} \end{pmatrix} \qquad (2\text{-}7)$$

Die Faktoren $x_1, x_2, ..., x_n$ entsprechen dann der gesuchten Verbraucherverteilung der Verbraucher in dem elektrischen Netz.

Wird das aus dem gemessenen Stromsignal des elektrischen Netzes bestimmte Netzspektrum $b$ analog zur Gleichung 2-6 normiert, so erhält man ein normiertes Gleichungssystem und in $x$ die normierte Verbraucherverteilung der Verbraucher in einem elektrischen Netz, wobei die Komponenten von $x$ Werte im Bereich zwischen 0 und 1 aufweisen.

$$x_1 \begin{pmatrix} a_{11} \\ a_{21} \\ . \\ . \\ a_{m1} \end{pmatrix} + x_2 \begin{pmatrix} a_{12} \\ a_{22} \\ . \\ . \\ a_{m2} \end{pmatrix} + ... + x_n \begin{pmatrix} a_{1n} \\ a_{2n} \\ . \\ . \\ a_{mn} \end{pmatrix} = \begin{pmatrix} b_1 \\ b_2 \\ . \\ . \\ b_m \end{pmatrix} \qquad (2\text{-}8)$$

Nach der Überführung in die Matrixschreibweise hat Gleichung 2-8 folgende Gestalt.

$$\underbrace{\begin{pmatrix} a_{11} & a_{12} & & a_{1n} \\ a_{21} & \cdot & & a_{21} \\ \cdot & & \cdot & \\ \cdot & & & \cdot \\ a_{m1} & \cdot & \cdot & a_{mn} \end{pmatrix}}_{A} * \underbrace{\begin{pmatrix} x_1 \\ x_2 \\ \cdot \\ \cdot \\ x_m \end{pmatrix}}_{x} = c \underbrace{\begin{pmatrix} b_1 \\ b_2 \\ \cdot \\ \cdot \\ b_m \end{pmatrix}}_{b} \qquad \Longleftrightarrow \qquad \vec{A}\vec{x} = \vec{b} \qquad \text{(2-9)}$$

$A \ni R^{m \times n}; x, b \ni R^m$

$m$ ist die Anzahl der betrachteten Harmonischen und $n$ die Anzahl der zugrunde gelegten Verbraucher (bzw. Verbraucherklassen). Der Vektor $b$ ist das Netzspektrum, das aus dem durch die Messvorrichtung 3 gemessenen Stromsignal des elektrischen Netzes 1 bestimmt ist, und der Vektor $x$ entspricht der gesuchten Verbraucherverteilung der Verbraucher 2a, 2b in dem elektrischen Netz. Die Verbrauchermatrix $A$ ist mathematisch betrachtet durch die fehlende Orthogonalität nur ein Unterraum des $n$-dimensionalen Raumes und wird durch ihre Spaltenvektoren, die die Verbraucherspektren darstellen, aufgespannt. Man kann sie als den "Frequenzverteilungsraum des Stromes in einem Verknüpfungspunkt" auffassen. Unabhängig davon, welche Kombination von Verbrauchern an diesem Punkt gerade vorliegt, befindet sich der Vektor des gemessenen Netzspektrums immer innerhalb dieses spezifischen Frequenzverteilungsraums. Somit ist mit diesem Ansatz bei Kenntnis der Verbraucher (bzw. der mehrere Verbraucher umfassende Verbraucherklassen) die Überlagerung aller definierten Verbraucher beschrieben.

**Zeitliche Signale** Bei Verwendung zeitlicher Signale anstelle des Netzspektrums und der Verbraucherspektren, also eines zeitlichen Netzsignals und zeitlicher Verbrauchersignale, in denen Stromwerte an dem Messpunkt eines elektrischen Netzes bzw. an den Verbrauchern zu unterschiedlichen Zeitpunkten gespeichert sind, ergibt sich ein zu Gleichung 2-9 analoges Gleichungssystem. Ersetzt man in Gleichung 2-9 die Spaltenvektoren der Matrix $A$ durch die entsprechenden, mit den Verbraucherspektren über eine Fouriertransformation gemäß Gleichung 2-3 verknüpften zeitlichen Verbrauchersignale und das Netzspektrum $b$ der rechten Seite durch das zeitliche Netzsignal, so erhält man die Formulierung des Gleichungssystem für zeitliche Signale. Die Normierung der Verbrauchersignale erfolgt dabei so, dass der Effektivwert der zeitlichen Signale genau 1 ergibt. Die Spaltenvektoren der Verbrauchersignale lauten dann:

$$\vec{I}_{j\_norm} = \frac{1}{\sqrt{\sum_{i=1}^{m} a_{ij}^2}} \begin{pmatrix} \overline{a}_{1j} \\ \overline{a}_{2j} \\ \cdot \\ \cdot \\ \overline{a}_{mj} \end{pmatrix} = \begin{pmatrix} a_{1j} \\ a_{2j} \\ \cdot \\ \cdot \\ a_{mj} \end{pmatrix} \qquad \text{(2-10)}$$

Analog wird auch das Netzsignal $b$ der rechten Seite normiert. Die nachfolgend beschriebenen Lösungsansätze zur Lösung des Gleichungssystems gemäß Gleichung 2-9 sind analog auch anwendbar bei Verwendung zeitlicher Signale.

### 2.3 Korrektur bei räumlich ausgedehnten Netzen

Der im vorangegangenen Abschnitt gezeigte Ansatz setzt eine vernachlässigbare Zeitverzögerung der Ströme im elektrischen Netz aufgrund der räumlichen Ausdehnung des elektrischen Netzes voraus. Kann die Ausdehnung nicht vernachlässigt werden, so gibt es folgende Möglichkeiten, diese zu berücksichtigen.

1. Die Verbraucher werden innerhalb des elektrischen Netzes unter Einbeziehung der Weglänge zwischen Verbraucher und Messpunkt ausgemessen und als Spaltenvektor definiert. Dadurch sind eventuelle Phasenverzerrungen in den Messergebnissen bereits in der Matrix enthalten und treten somit nicht als Fehler in Erscheinung.
2. Die spezifischen Spektren müssen mit einer Frequenzvektorverzögerungskorrektur versehen werden.

**Frequenzvektorverzögerungskorrektur** Eine zeitliche Verzögerung durch die räumliche Ausdehnung des elektrischen Netzes führt nicht zu einer identischen Phasenverschiebung der Harmonischen der Stromsignale, d.h., es gibt keine entsprechende Phasendrehung aller Komponenten eines Frequenzvektors. Jede Komponente des Vektors bekommt eine eigne Phasendrehung.

$$\vec{F}_j = \begin{pmatrix} a_{1j} \\ a_{2j} \\ . \\ . \\ a_{mj} \end{pmatrix} = \begin{pmatrix} |a_{1j}|e^{j\omega t}e^{\varphi_1} \\ |a_{2j}|e^{j3\omega t}e^{\varphi_3} \\ . \\ . \\ |a_{mj}|e^{j19\omega t}e^{\varphi_{19}} \end{pmatrix} = \begin{pmatrix} |a_{1j}|e^{j\omega t+\varphi_1} \\ |a_{2j}|e^{j3\omega t+\varphi_3} \\ . \\ . \\ |a_{mj}|e^{j19\omega t+\varphi_{19}} \end{pmatrix} \qquad \textbf{(2-11)}$$

Der erste Term der *e*-Funktion repräsentiert die Rotation der Zeiger. Diese drehen genau mit der Grundfrequenz bzw. mit deren Vielfachen für die Harmonischen höherer Ordnung und sind damit für die Frequenzdarstellung uninteressant. Der zweite Term stellt die Phasenverschiebung dar und wird daher in einer komplexen Zeigerdarstellung im Frequenzbereich zusammen mit dem Betrag angegeben.

$$\vec{F}_j = \begin{pmatrix} |a_{1j}|e^{j\varphi_1} \\ |a_{2j}|e^{j\varphi_3} \\ . \\ . \\ |a_{mj}|e^{j\varphi_{19}} \end{pmatrix} \qquad \textbf{(2-12)}$$

Mit dieser Darstellung kann wie mit den normalen komplexen Verbraucherspektren gerechnet werden. Im Fall einer Verzögerung im Zeitbereich aufgrund der endlichen Ausbreitungsgeschwindigkeit im Netz ergibt sich allerdings eine zusätzliche Phasenverschiebung, bei der aus der Zeitverzögerung $\Delta t = T_d$ im Zeitbereich der Faktor $e^{jw\Delta t} = e^{j\varphi}d$ als Phasenverschiebung resultiert. Ist der gesamte Frequenzvektor eines Verbrauchers verzögert, so muss der phasenverschiebende Faktor für jede Komponente separat berechnet werden.

$$\vec{F}_j(\vec{f}(t-d))(\vec{\omega}) \neq \begin{pmatrix} |a_{1j}|e^{j\varphi_1} \\ |a_{2j}|e^{j\varphi_3} \\ . \\ . \\ |a_{mj}|e^{j\varphi_{19}} \end{pmatrix} e^{j\varphi_d} \qquad \textbf{(2-13)}$$

Wenn *n* die Ordnung der Harmonischen ist, die der *i*-ten Komponente des Frequenzvektors *j* zugeordnet wird, dann muss eine Zeitverschiebung wie folgt behandelt werden:

$$\vec{F}_{d;j}(\vec{f}(t-d))(\vec{\omega}) = \underbrace{\begin{pmatrix} a_{1j} & 0 & \cdots & 0 \\ 0 & a_{2j} & \cdot\cdot & \vdots \\ \vdots & \cdot\cdot & \ddots & 0 \\ 0 & 0 & \cdots & a_{mj} \end{pmatrix}}_{IF} \underbrace{\begin{pmatrix} e^{jn_1\varphi_d} \\ e^{jn_2\varphi_d} \\ \cdot \\ \cdot \\ e^{jn_m\varphi_d} \end{pmatrix}}_{Phasenkorrekturvektor} \qquad (2\text{-}14)$$

Aus dem komplexen exponentiellen Korrekturfaktor wird in diesem Fall ein exponentieller Korrekturvektor, welcher jeder Komponente des Verbraucherspektrums eines Verbrauchers eine eigene Phasenkorrektur zukommen lässt. Dieser Zusammenhang gilt jedoch nur bei der frequenzunabhängigen Ausbreitungsgeschwindigkeit des Stromes, also in dispersionsfreien Leitern. Ist dies nicht der Fall, muss die unterschiedliche Laufzeit der Frequenzen ermittelt und in den Korrekturvektor eingebracht werden. Ist $\Delta v_n$ die Ausbreitungsgeschwindigkeitsdifferenz der $n$-ten Harmonischen gegenüber dem 50Hz Strom und $l_j$ die Entfernung des $j$-ten Verbrauchers vom Messort, so wird die Verzögerungskorrektur wie folgt erweitert:

$$\vec{F}_j(f(t-d))(\vec{\omega}) = \begin{pmatrix} a_{1j} & 0 & \cdots & 0 \\ 0 & a_{2j} & \cdot\cdot & \vdots \\ \vdots & \cdot\cdot & \ddots & 0 \\ 0 & 0 & \cdots & a_{mj} \end{pmatrix} \begin{pmatrix} e^{jn_1(\varphi_d+\omega\Delta v_{n_1}l_j)} \\ e^{jn_2(\varphi_d+\omega\Delta v_{n2}l_j)} \\ \cdot \\ \cdot \\ e^{jn_m(\varphi_d+\omega\Delta v_{n_m}l_j)} \end{pmatrix} \qquad (2\text{-}15)$$

Da die Bestimmung der Dispersion schwierig ist, muss der Fehler, der durch das Auslassen der Korrektur entsteht, bestimmt werden. Ist die relative Ausbreitungsgeschwindigkeit von Strömen in elektrischen Netzen in Relation zur Lichtgeschwindigkeit $v_r$ und die maximal zulässige Phasenverschiebung $\Delta\varphi$, so ergibt sich die maximal zulässige Leitungslänge durch:

$$l_{max} = v_r c \frac{\Delta\varphi}{2\pi} \frac{1}{f_{max}} \quad \text{wobei } v_r \text{ die Relation zur Lichtgeschwindigkeit ist.} \quad (2\text{-}16)$$

Bei zeitlichen Signalen erfolgt eine Korrektur nicht mittels eines Korrekturfaktors zur Kompensation einer Phase, sondern mittels einer zeitlichen Verschiebung der Signale, wobei sich die zeitliche Verschiebung direkt aus der Zeitverzögerung in Folge der Leitungslängendifferenz zwischen den Verbrauchern ergibt.

**Beispiel eines Fehlers durch räumliche Ausdehnung** Wird z.B. bei $v_r$=0.66 und 2KHz als höchste Frequenz im Spektrum (40. Harmonische) eine zulässige Phasentoleranz von $\pi/50$ angenommen, so ergibt sich eine maximal zulässige Leitungslänge von 1 km. Der durch die Verzögerung entstehende Phasenfehler nimmt mit der Frequenz linear ab und spielt daher nur bei der Betrachtung Harmonischer höherer Ordnung eine Rolle.

Die errechnete zulässige maximale Leitungslänge bezieht sich lediglich auf die Leitungslängendifferenz zwischen verschiedenen Verbrauchern einer Verbraucherklasse untereinander bzw. auf die Leitungslängendifferenz zwischen dem Verbraucher und dem Messpunkt des elektrischen Netzes im Betrieb. Der durch die Leitungslängendifferenz zum Messpunkt des elektrischen Netzes eingeführte Fehler für eine Verbraucherklasse lässt sich aber vollständig eliminieren, indem die Bestimmung der Verbraucherklassen am Messpunkt des elektrischen Netzes erfolgt. Damit sind alle Phasenverschiebungen der Harmonischen bereits im spezifischen Verbraucherspektrum der Verbraucher und Verbraucherklassen enthalten.

**2.4 Lösung des komplexen Gleichungssystems**

Zur Aufstellung der Gleichung $\vec{A}\vec{x} = \vec{b}$ werden in der Regel mehr Oberschwingungen ausgewertet als Verbraucherklassen vorhanden sind, so dass ein überbestimmtes, komplexes, lineares Gleichungssystem (LGS) erzeugt wird, welches entsprechend einem reellen LGS entweder eine oder gar keine Lösung hat. Genau eine Lösung erhält man, wenn sich der Vektor b innerhalb des Spaltenunterraumes von A befindet, d.h. wenn sich b aus einer echten Linearkombination der Spaltenvektoren bilden lässt. Diese Situation ergibt sich in der Realität in der Regel nicht, da

1. der Vektor *b* das aus dem gemessenen Stromsignal des elektrischen Netzes am Messpunkt gebildete Netzspektrum ist und somit messfehlerbehaftet ist,
2. zur Bildung von Verbraucherklassen, in denen einzelne Verbraucher zusammengefasst sind, Toleranzen in der Abweichung der Verbraucherspektren der einzelnen Verbraucher definiert und in Kauf genommen werden,
3. das weiße Rauschen in den Messvorrichtungen einen statistisch gleichverteilten Fehler erzeugt,
4. durch das in den Messvorrichtungen zur Messung eines Stromsignals vorgenommene Abtasten ein statistisch gleichverteilter Quantisierungsfehler entsteht,
5. und Verbraucher zugeschaltet sein können, die nicht zu einer definierten Klasse gehören.

Die Lösbarkeit überbestimmter LGS lässt sich mathematisch durch den Rang der Matrix *A* ermitteln. Ist der Rang der Matrix *A* gleich dem Rang der durch den Vektor *b* erweiterten Matrix, so existiert genau eine Lösung. In diesem Fall ist der das Netzspektrums des elektrischen Netzes darstellende Vektor *b* linear von den Spaltenvektoren abhängig und somit Teil des Unterraumes von *A*. Mathematisch lässt sich dieses wie folgt ausdrücken:

$$rank(A) = rank(A|b) \Rightarrow Ax = b \qquad \text{hat eindeutige Lösung} \qquad \textbf{(2-17)}$$

Hierbei ist der Spaltenrang gleich dem Zeilenrang und dies entspricht der Anzahl der Verbraucher. Ein Beispiel dafür ist im folgenden Abschnitt zu sehen.

**Beispiel zur Lösbarkeit** Als Beispiel wurde der Rang der Matrix *A* (gebildet aus den gemessenen Verbraucherspektren zweier Verbraucher) und der ihrer erweiterten Matrix (*A*|*b*) überprüft. Der Vektor *b* ist dabei das Netzspektrum verursacht durch die Überlagerung dieser beiden Verbraucher.

$$rank\begin{pmatrix} 0,99726 - 0,07397i & 0,73525 + 0,6778i \\ 0,03709 + 0,20957i & -0,01205 - 0,0030316i \\ -0,80988 - 0,26564i & 0,02393 + 0,02515i \\ 0,59912 + 0,17081i & -0,00813 + 0,0093073i \\ 0,03649 + 0,09231i & -0,00092 + 0,00045077i \\ -0,29684 - 0,20344i & 0,00200 - 0,0016949i \\ 0,13632 + 0,07692i & -0,00082 - 0,00062151i \\ 0,05893 + 0,00951i & -0,00077 + 0,00034278i \\ -0,09818 + 0,02798i & 0,00027 + 0,00090452i \\ 0,034843 - 0,04126i & -0,00033 + 9,655e - 005i \end{pmatrix} = 2 \qquad \textbf{(2-18)}$$

$$rank \begin{pmatrix} 0,99726 - 0,07397i & 0,73525 - 0,67789i & 0,73516 - 0,67789i \\ 0,03709 + 0,20957i & -0,012050 - 0,0030i & -0,00327 - 0,06846i \\ -0,80988 - 0,26564i & 0,023930 + 0,02515i & -0,51000 - 0,072017i \\ 0,59912 + 0,17081i & -0,00818 + 0,00930i & 00,37772 + 0,15698i \\ 0,03649 + 0,09231i & -0,000922 + 0,00045i & -0,00079 - 00,023322i \\ -0,29684 - 0,20344i & 0,002006 - 0,001690i & -0,170980 - 0,09899i \\ 0,13632 + 0,07692i & -0,000826 - 0,000620i & 0,116570 + 0,06157i \\ 0,05893 + 0,00951i & -0,000775 + 0,00031i & -0,016639 - 0,0020653i \\ -0,09811 + 0,02795i & 0,0002736 + 0,0009i & -0,042881 + 0,013143i \\ 0,03484 - 0,041269i & -0,0003317 + 9,6e-5i & 0,046343 - 0,030897i \end{pmatrix} = 3 \qquad \textbf{(2-19)}$$

Der Rang der erweiterten Matrix ($A|b$) ist größer als der Rang der Matrix $A$, obwohl der Vektor $b$ bis auf einen reellen linearen Normierungsfaktor das Messergebnis der physikalischen Überlagerung der beiden Spaltenvektoren der Matrix $A$ ist. Eine Addition mit anschließender Normierung der ersten beiden Spalten ergibt dabei einen dem Vektor $b$ sehr ähnlichen Vektor, aber eben nicht den Vektor $b$. Die euklidische Norm des Fehlervektors zwischen der Summe der Spaltenvektoren und des Messvektors ist hier ein Maß für den Messfehler. Das Gleichungssystem ist also nicht eindeutig für $b$ lösbar.

Zur Analyse muss das lineare Gleichungssystem gemäß Gleichung 2-9 also näherungsweise gelöst werden. Im Folgenden sind unterschiedliche Ansätze zur Analyse des Gleichungssystems beschrieben.

**Projektion von b auf den Unterraum A** Die Idee der Projektion ist, einen Vektor $p$ zu finden, der sich im Spaltenunterraum von $A$ befindet und dem Vektor $b$ am nächsten kommt. Dieser Vektor entspricht der orthogonalen Projektion von $b$ auf $A$. Der Zusammenhang der Vektoren $b$ und $p$ ist in Figur 7 veranschaulicht.

Das unter Einbeziehung der Projektion $p$ gebildete Gleichungssystem

$$A\vec{x} = \vec{p} \qquad \textbf{(2-20)}$$

ist eindeutig lösbar. Der Vektor $p$ wird dabei bestimmt durch die Projektionsmatrix $P$, die den Vektor $b$ in den Unterraum von $A$ dreht und auf die Länge seiner orthogonalen Projektion skaliert.

$$\vec{p} = P\vec{b} \qquad \textbf{(2-21)}$$

Zur Bestimmung der Projektionsmatrix $P$ wird zunächst die Differenz der Vektoren $b$ und $p$ betrachtet, die dem Vektor $e$ (error) entspricht und wegen der orthogonalen Eigenschaft der Projektion senkrecht auf $A$ und damit auch senkrecht auf $p$ steht.

$$\vec{e} = \vec{b} - \vec{p} \qquad \textbf{(2-22)}$$

Da $e$ senkrecht zum von $A$ aufgespannten Unterraum steht, ergibt sich:

$$A^T\vec{e} = \vec{0} \qquad \textbf{(2-23)}$$

Somit gilt

$$A^T(b - Ax) = 0 \Rightarrow A^T b = A^T Ax \qquad \textbf{(2-24)}$$

Daraus ergibt sich:

$$[A^T A]^{-1} A^T \vec{b} = \vec{x} \qquad\qquad (2\text{-}25)$$

Werden jetzt beide Seiten mit *A* multipliziert, ergibt sich die Projektionsmatrix *P*:

$$Ax = A[A^T A]^{-1} A^T b \Rightarrow p = \underbrace{A[A^T A]^{-1} A^T}_{P} b \qquad\qquad (2\text{-}26)$$

$$P = A[A^T A]^{-1} A^T \qquad\qquad (2\text{-}27)$$

Die Projektionsmatrix *P* projiziert also den Vektor *b* in den Spaltenraum von *A*. Die gesuchte Lösung in *x* ergibt sich dann zu:

$$x = [A^T A]^{-1} A^T b \qquad\qquad (2\text{-}28)$$

Sind *A* und *b* komplex, so muss in Gleichung 2-28 die transponierte Matrix $A^T$ durch die Hermitische $A^H$ ersetzt werden. Gleichung 2-28 entspricht dabei dem aus der Messtechnik bekannten "least square"-Lösungsansatz.

Für den komplexen Fall ergibt sich die Lösung: $x,b \in C^m; A \in C^{m \times n}$

$$x = [A^H A]^{-1} A^H b \qquad\qquad (2\text{-}29)$$

**Erweiterung auf den Fall der Unterbestimmtheit** Die gezeigte Lösung ist nur gültig für die *Fälle, A* $\in C^{m \times n}$, $m \geq n; rank(A) = n$, d.h., wenn *A* den vollen Rang (Spaltenrang) hat. Sollen mehr Verbraucher (bzw. Verbraucherklassen) als erfasste Harmonische identifiziert werden, entsteht ein unterbestimmtes Gleichungssystem. Ein solches Gleichungssystem weist ebenfalls keine eindeutige Lösung, sondern unendlich viele Lösungen auf. In diesem Fall, welcher als "rangdefektes oder "singuläres Ausgleichsproblem" bezeichnet wird, bietet sich es an, den Lösungsvektor mit der kleinsten Länge zu finden. Dazu werden die Matrizen *U* und *V* wie folgt definiert.

$$U = \begin{bmatrix} orthogonale \\ Eigenvektoren \\ von : A^T A \end{bmatrix} \qquad V = \begin{bmatrix} orthogonale \\ Eigenvektoren \\ von : AA^T \end{bmatrix} \qquad (2\text{-}30)$$

Weiterhin sei $A = USV^T$ eine Singulärwertzerlegung von *A*.

Die Lösung kleinster Länge ist dann definiert als:

$$x^+ = VS^+ U^T b = A^+ b \qquad\qquad (2\text{-}31)$$

Die Matrix $A^+$ ist die Pseudoinverse bzw. Moore-Penrose-Inverse von *A*. Sie ist die natürliche Verallgemeinerung der Inversen einer regulären Matrix. Diese löst ein lineares Gleichungssystem (LGS) immer und bietet sich für die Berechnung der Verbraucherverteilung *x* an.

Zusammengefasst ergeben sich folgende Fälle, die alle mittel der Moore-Penrose-Inversen lösbar sind:

1. Ist A regulär: *x* ist eindeutige Lösung, wie $x = A^{-1}b$

2. Ist das LGS überbestimmt: $x$ ist die "least square" - Lösung
3. Bei Rangdefektheit: $x$ ist "Lösung kleinster Länge"
Im dritten Fall können sich dabei in Abhängigkeit von dem Grad des Rangdefektes Ungenauigkeit in der errechneten Verbraucherverteilung ergeben.

### 2.4.1 Amplitudenbetragsspektrumansatz

Es ist denkbar, dass der Einsatz bestimmter Messvorrichtungen die Bestimmung ausschließlich der Beträge der Spektren ermöglicht. In dem Fall gehen, trotz der eigentlich komplexen Natur der Verbraucherspektren und des Netzspektrums, in der Gleichung $\vec{x} = inv\left[A'A\right]A'\vec{b}$ ausschließlich die Beträge der durch die Verbraucherspektren gebildeten Verbraucher Matrix $A$ und des Netzspektrums $b$ ein.

Durch die Vernachlässigung der Phaseninformation bei der Erfassung ausschließlich der Beträge der Verbraucherspektren und des Netzspektrums kann es allerdings zu Ungenauigkeiten in der Lösung des Gleichungssystems kommen.

### 2.4.2 Komplexer Spektrumansatz

Liefert eine Messvorrichtung komplexwertige Verbraucher- und / oder Netzspektren, so erfolgt die Aufstellung des komplexen LGS. Hierbei ist zu beachten, dass statt den Transponierten von $A$ die Hermitische von $A$ in das Gleichungssystem eingeht.

$$\vec{x} = \left[A^H A\right]^{-1} A^H \vec{b} \qquad (2\text{-}32)$$

Die Lösung $x$ kann dabei sowohl reell als auch komplex sein. Ist $b$ eine rein reelle Überlagerung der Spaltenvektoren, also eine echte reelle Gewichtung, dann ist die Lösung reell und interpretierbar. Ist die Lösung nicht reell, so kann zur Interpretierung der Lösung der Betrag der Komponenten von $x$ gebildet werden und als Verbraucherverteilung der Verbraucher im elektrischen Netz interpretiert werden.

### 2.4.3 Reeller Ansatz durch Trennung von Imaginär und Realteil

Da $x$ die anteilige Verbraucherverteilung der Verbraucher im elektrischen Netz beschreibt, sollte x reellwertig sein. Es ist denkbar, zur Bestimmung von $x$ die komplexe Überlagerung der Verbraucherspektren durch ein reelles $x$ anzunähern, d.h. ein rein reelles $x$ zu finden, bei dem die quadratischen Abstände der komplexen Zahlen auf der linken und rechten Seite des Gleichungssystems $A\vec{x} = \vec{b}$ ein Minimum aufweisen.

Es sei $\vec{a}_j \in C^m$ Spaltenvektor der j-ten Spalte der Matrix A und $x_j \in R$.

$$\underbrace{re(\vec{b}) + i(im(\vec{b})) = x_1(re(\vec{a}_1)) + x_2(re(\vec{a}_2)) + \ldots + x_n(re(\vec{a}_n))}_{real}$$
$$+ i\underbrace{(x_1(im(\vec{a}_1)) + x_2(im(\vec{a}_2)) + \ldots + x_n(im(\vec{a}_n)))}_{im} \qquad (2\text{-}33)$$

Der Vektor $x$ lässt sich hieraus wie folgt bestimmen:

$$\arg\min_{x} \left\| \left| Re((A))\vec{x} - \vec{b} \right|^2 + \left| Im((A))\vec{x} - \vec{b} \right|^2 \right\| \qquad (2\text{-}34)$$

Dafür lässt sich wiederum ein analytisches Gleichungssystem aufstellen.

$$\begin{pmatrix} \text{Re}(A) \\ \text{Im}(A) \end{pmatrix} \vec{x} = \begin{pmatrix} \text{Re}(\vec{b}) \\ \text{Im}(\vec{b}) \end{pmatrix} \qquad \textbf{(2-35)}$$

Dieses Gleichungssystem lässt sich analytisch durch die Projektion der rechten Seite auf den jetzt reellen Unterraum der Matrix $A$ der linken Seite lösen:

$$\vec{x} = \left[ \begin{pmatrix} \text{Re}(A) \\ \text{Im}(A) \end{pmatrix}^T * \begin{pmatrix} \text{Re}(A) \\ \text{Im}(A) \end{pmatrix} \right]^{-1} * \begin{pmatrix} \text{Re}(A) \\ \text{Im}(A) \end{pmatrix}^T * \begin{pmatrix} \text{Re}(\vec{b}) \\ \text{Im}(\vec{b}) \end{pmatrix} \qquad \textbf{(2-36)}$$

Da das so erhaltene Gleichungssystem reell ist, ist auch der Vektor $x$ reell und kann direkt als Verbraucherverteilung der Verbraucher im elektrischen Netz angesehen werden.

Es hat sich jedoch gezeigt, dass der Ansatz gemäß Gleichung 2-36 keine brauchbare Lösung liefert. Daher kann der Ansatz auf die reellwertige Darstellung eines komplexen Gleichungssystems erweitert werden, die im Folgenden in Gleichung 2-37 dargestellt ist. Die Lösung dieser Gleichung entspricht der Lösung gemäß Gleichung 2-29. Im Unterschied zu Gleichung 2-29 weist der die Verbraucherverteilung der Verbraucher im elektrischen Netz darstellende Vektor $x$ in diesem Fall doppelt so viele Komponenten auf, wobei die erste Hälfte der Komponenten den Realteil und die zweite Hälfte den Imaginärteil von $x$ darstellt. Diese Darstellung ermöglicht einen schnellen Überblick über die Größenordnungen der Imaginärteile von $x$.

$$\begin{pmatrix} \text{Re}(A) & -\text{Im}(A) \\ \text{Im}(A) & \text{Re}(A) \end{pmatrix} \vec{\tilde{x}} = \begin{pmatrix} \text{Re}(\vec{b}) \\ \text{Im}(\vec{b}) \end{pmatrix} \qquad \begin{pmatrix} \left.\begin{matrix} \text{Re}(x_1) \\ \text{Re}(x_2) \\ \\ \\ \text{Re}(x_n) \end{matrix}\right\} = \text{Re}(\vec{x}) \\ \left.\begin{matrix} \text{Im}(x_1) \\ \text{Im}(x_2) \\ . \\ . \\ \text{Im}(x_n) \end{matrix}\right\} = \text{Im}(\vec{x}) \end{pmatrix} = \vec{\tilde{x}} \qquad \textbf{(2-37)}$$

### 2.4.4 Numerische Optimierung

Eine weitere Möglichkeit zur Lösung des linearen Gleichungssystems ist die Anwendung eines numerischen Optimierungsalgorithmus. Der Vorteil besteht darin, das die Genauigkeit und der Rechenaufwand frei gewählt werden kann. Der zu variierende Vektor $x$ kann je nach Implementierung beliebig reell oder auch komplex sein. Das Problem lässt sich als Minimierungsproblem darstellen:

$$\arg\min_x \left\| A\vec{x} - \vec{b} \right\|_2^2 \quad \text{wobei} \quad \left\| .. \right\|_2^2 \text{ die quadratisch euklidische Norm eines Vektors ist.} \qquad \textbf{(2-38)}$$

Setzt man:

$$F(x) = |\, A\vec{x} - \vec{b}\, | \tag{2-39}$$

und führt die Berechnung der euklidischen Norm aus, so lautet das Minimierungsproblem:

$$\arg\min_{\underline{x}} \sum_{i=1}^{m} F_i^2(\vec{x}) \tag{2-40}$$

$F_i(\vec{x})$ ist die Abweichung einer Komponente in der Gleichung F(x) von der exakten Lösung des Gleichungssystems. Der Algorithmus bestimmt nun den Vektor, bei dem $F(x)$ ein globales Minimum bzw. ein Minimum innerhalb des Unterraums, der sich aus den festgelegten Grenzen für $x$ ergibt, aufweist.

**Fehler bei numerischen Verfahren**   Zur Unterscheidung der möglichen Ursachen für fehlerhafte Lösungen von numerischen Problemen werden die Fehler beim Übergang zur numerischen Darstellung in folgende Klassen unterteilt:

- Datenfehler oder Eingansfehler resultieren z.B. aus verrauschten Messgrößen. Ihre Auswirkung auf die Lösung lassen sich nicht vermeiden. Ihr Einfluss auf das Ergebnis aber muss untersucht und minimiert werden. Im vorliegenden Fall gibt es Messfehler beim Bestimmen des Netzspektrums, also im Vektor $b$.
- Klassifizierungsfehler entstehen durch das Zusammenfassen der Verbraucher in Klassen. Hier haben die Verbraucher einer Klasse nicht exakt dasselbe spezifische Verbraucherspektrum. Vielmehr wurden Toleranzen definiert, und alle Verbraucher innerhalb dieser Toleranzen in dieser Klasse zusammengefasst.
- Verfahrensfehler entstehen durch nicht vollständige Modellierung des Problems, durch Diskretisierung oder durch die endliche Anzahl von Schritten bei Iterationsverfahren.
- Rundungsfehler entstehen aus der Art der Zahlendarstellung und dem begrenzten Zahlenbereich im Rechner selbst. Diese Fehler werden oft unterschätzt.

Als Erstes werden der absolute und der relative Fehler definiert:

$$\varepsilon_k = x_k - \tilde{x}_k;\; \tilde{x}_k \Leftrightarrow N\ddot{a}herung \Rightarrow \delta_k = \frac{x_k - \tilde{x}_k}{x_k} \Rightarrow rel.Fehler \tag{2-41}$$

**Kondition eines Problems**   Die Daten und Eingangsfehler wirken sich in Abhängigkeit der Konditionierung des Problems aus. Ein Problem wird als gut konditioniert bezeichnet, wenn geringe Änderungen in den Eingangsdaten auch nur geringe Änderungen in den Ergebnissen liefern. Schlecht konditioniert hingegen ist ein Problem, wenn geringe Änderungen am Eingang zu großen Abweichungen vom Ergebnis führen. Ein schlecht konditioniertes Problem kann auch mit einem sehr guten und numerisch stabilen Algorithmus nicht befriedigend gelöst werden.

Zur Abschätzung der Konditionierung werden Konditionszahlen definiert. Lineare Gleichungssysteme wie das hier verwandte sind oft sehr schlecht konditioniert. Zur Fehlerabschätzung wird die Konditionszahl der Matrix $A$ wie folgt definiert:

Durch die Störung $\Delta b$ entsteht eine Störung $\Delta x$.

$$A(\vec{x} + \vec{\Delta x}) = \vec{b} + \vec{\Delta b} \;\;\rightarrow\;\; A\vec{\Delta x} = \vec{\Delta b} \;\;\rightarrow\;\; \vec{\Delta x} = pinv(A)\vec{\Delta b} \tag{2-42}$$

Dabei ist *pinv(A)* =$A^+$ die Pseudoinverse von *A*.

Der Fehler $\Delta x$ kann mit Hilfe der Matrixnormen abgeschätzt werden:

$$\left\|\Delta\vec{x}\right\| \leq \left\|pinv(A)\right\|\left\|\Delta\vec{b}\right\| \qquad\qquad \textbf{(2-43)}$$

Der relative Fehler ergibt dann sich zu:

$$\frac{\left\|\Delta\vec{x}\right\|}{\left\|\vec{x}\right\|} \leq \left\|A^{-1}\right\|\left\|A\right\|\frac{\left\|\Delta\vec{b}\right\|}{\left\|\vec{b}\right\|} \qquad\qquad \textbf{(2-44)}$$

Der Faktor $\|A^{-1}\|*\|A\|$ wird Konditionszahl der Matrix $A$, *cond(A)* genannt.

Der Wert $\log_{10}(\text{cond}(A))$ gibt in etwa die Zahl der Dezimalstellen an, die bei der Lösung des linearen Gleichungssystems durch Rundungsfehler verloren gehen. Ein Indiz für eine schlechte Konditionierung des Problems ist gegeben, wenn:

$$cond(A) >> \frac{1}{\sqrt{eps}} \qquad\qquad \textbf{(2-45)}$$

Der Größe *eps* ist hier der Abstand von einer Zahl zu der nächst größeren darstellbaren Zahl in einer Rechnereinrichtung (beispielsweise die Präzision in der Floating-Point-Darstellung).

**Numerische Stabilität** Die numerische Stabilität oder Instabilität beschreibt im Gegensatz zur Kondition die Auswirkung des verwendeten Algorithmus auf das Ergebnis. In der in einem Rechner verwendeten Gleitkommarithmetik, werden die Zahlen während der Berechnung oft gerundet. Dies führt zur Auslöschung von Stellen, was bei mehrstufigen Berechnungen zum Aufschaukeln der Fehler und numerischer Instabilität führen kann. Dieses Phänomen wird als Fehlerfortpflanzung bezeichnet.

### 2.4.5 Verbesserung der Kondition des LGS durch Auswertung der Kovarianzen

Aus der Theorie der linearen Algebra geht hervor, dass, wenn sich zwei oder mehrere Spaltenvektoren einer Matrix im linearen Sinne zu nahe kommen, sich die Konditionszahl der Matrix vergrößert. Dieses tritt bei Verbrauchern mit nahezu linear abhängigen Verbraucherspektren auf.

Bei der Analyse auftretende Fehler lassen sich häufig auf die hohe Konditionszahl der aus den Verbraucherspektren gebildeten Verbrauchermatrix zurückführen. Eine hohe Konditionszahl deutet darauf hin, dass die Matrix Spaltenvektoren, die nah an der linearen Abhängigkeit liegen, aufweist.

Um zu verhindern, dass Spaltenvektoren sich linear zu nahe kommen, muss die Matrix aus Verbraucherspektren von solchen Verbrauchern gebildet werden, die sich signifikant unterscheiden. Wenn die Verbraucher vorgegeben sind, muss ein Weg gefunden werden, die Verbraucher so in Verbraucherklassen zusammenzulegen, dass die Verbraucherspektren innerhalb einer Verbraucherklasse ein Höchstmaß an Ähnlichkeit aufweisen, die Verbraucherspektren der Verbraucherklassen untereinander hingegen sich signifikant unterscheiden.

Die Korrelationskoeffizienten der Verbraucherspektren untereinander können gut durch die Kovarianzmatrix $R$ dargestellt werden. Die Elemente $r_{ij}$ der Matrix $R$ sind dann die empirischen Korrelationskoeffizienten der Verbraucherspektren und sind ein Maß für die Ausprägung des linearen Abhängigkeit der Verbraucherspektren voneinander. Die Korrelation der Verbraucherspektren beeinflusst in wesentlichem Maße die Konditionierung der Verbrauchermatrix $A$.

Zur Berechnung der Kovarianzmatrix $R$ werden die Spaltenvektoren, also die Verbraucherspektren, der Matrix $A$ mittelwertfrei gemacht, und die mittelwertfreien Spaltenvektoren werden mit dem Kehrwert ihrer euklidischen Norm skaliert. Es entsteht die Matrix $U$.

Die Kovarianzmatrix $R$ wird dann wie folgt definiert.

$$R = U^{H}U \qquad\qquad \textbf{(2-46)}$$

*R* erhält dadurch folgende Gestalt:

$$R = \begin{pmatrix} 1 & r_{12} & . & r_{1n} \\ r_{21} & 1 & . & . \\ . & . & . & . \\ r_{m1} & . & . & 1 \end{pmatrix}$$

(2-47)

Die normierten Korrelationskoeffizienten errechnen sich dann auf folgende Weise:

$$r_{xy} = \frac{\sum_{i=1}^{m}(a_{ix} - \overline{a}_x)(a_{iy} - \overline{a}_y)}{\sqrt{\sum_{i=1}^{m}(a_{ix} - \overline{a}_x)^2 \sum_{i=1}^{m}(a_{iy} - \overline{a}_y)^2}}$$

(2-48)

$\alpha_x$ und $\alpha_y$ seien hier die als Zeilenvektoren notierten Verbraucherspektren der Matrix *A* und $\alpha_{ix}$ und $\alpha_{iy}$ die Komponenten der Verbraucherspektren (komplexen Amplituden).

Korrelationskoeffizienten kleiner als 0,9 sind in der Regel als hinreichend klein zu bezeichnen.

Große Korrelationskoeffizienten stehen für einen stark ausgeprägten linearen Zusammenhang der betroffenen Verbraucherspektren.

Wird ein Schwellenwert definiert und werden alle Verbraucher mit Korrelationskoeffizienten oberhalb dieses Schwellenwertes zu einer Verbraucherklasse zusammengelegt, so lässt sich Größe der Verbrauchermatrix verringern und die Konditionszahl der so geschaffenen, neuen Matrix verkleinern.

Das Verbraucherspektrum der Verbraucherklasse ergibt sich aus Verbraucherspektren der in der Verbraucherklasse zusammengefassten Verbrauchern. Werden zwei Verbraucher in eine Verbraucherklasse zusammengefasst, so ergibt sich das Verbraucherspektrum der Verbraucherklasse, indem die Verbraucherspektren der zwei Verbraucher addiert werden und der entstandene Summenvektor wieder auf seine erste Komponente, also auf die Grundschwingung, normiert wird:

$$\vec{a}_{mix} = \frac{1}{\left|\vec{a}_{11} + \vec{a}_{12}\right|}(\vec{a}_1 + \vec{a}_2)$$

(2-49 )

Dadurch erhält man einen Mittelwert der Verbraucherspektren. Wird ein weiterer Verbraucher der Verbraucherklasse hinzugefügt, so ergibt sich das neue Verbraucherspektrum der Verbraucherklasse analog.

Auf diese Weise lassen sich große Korrelationen zwischen den die Spalten der Matrix *A* ausbildenden Verbraucherspektren reduzieren. Die Spalten sind nun weiter von der linearen Abhängigkeit entfernt und der Raum, der durch die Spalten aufgespannt wird, ist weniger stark verzerrt. Die Lösung des LGS wird dadurch robuster und weniger fehleranfällig. Durch die verbesserte Konditionierung des Problems haben kleine Messfehler keine großen Auswirkungen auf das Messergebnis.

Prinzipiell sind auch vollständig andere Ansätze denkbar, bei denen Ungenauigkeiten in Folge einer schlechten Matrixkonditionierung nicht auftreten oder eine weniger entscheidende Rolle spielen. Mögliche Ansätze zur Analyse des Modells sind beispielsweise Signalidentifikationsansätze aus der Mobilkommunikation, wie z.B. die "Maximum-Likelihood Detection" -Methode, unter Umständen erweitert durch ein "Latice Reduction"-Algorithmus. Auch andere Frequenzanalyseverfahren, wie z.B. der Einsatz von Wavelets, sind denkbar. Ein weiterer Ansatz aus der Diagnosetechnik, die so genannte "Blinde Quellentrennung", kann darüber hinaus eingesetzt werden, um die Ergebnisse zu verbessern.

### 2.4.6 Aufstellen der Verbrauchermatrix A

Es ist zweckmäßig, die Verbraucher eines Teilnetzes unter Einbeziehung der Kovarianzmatrix R zu klassifizieren. Ein denkbarer Weg ist, von einem großen Teil der vorkommenden Verbraucher in einem Teilnetz die Verbraucherspektren auszumessen und mit den Verbraucherspektren als Spaltenvektoren die Matrix *A* zu bilden. Sind alle Spektren gefunden, wird aus der jetzt großen Matrix *A* die Kovarianzmatrix berechnet und ein Schwellenwert für die empirischen Korrelationskoeffizienten festgelegt. Aus den hier untersuchten Versuchsreihen hat sich für diesen Schwellenwert ein Wert zwischen 0.9 und 0.95 bewährt.

Der Schwellenwert ist abhängig von der Genauigkeit der verwendeten Messtechnik und der Störeinflüsse in einem Netz. Denkbar ist auch ein Wert unter 0,9, wenn beispielsweise nur zwischen typischen Grundklassen und linearen Verbrauchern unterschieden werden soll.

Sind alle Korrelationskoeffizienten oberhalb des Schwellenwertes in der Kovarianzmatrix identifiziert, werden aus den durch die durch die jeweiligen allen Paaren bzw. Gruppen dieser Verbraucher jeweils die geometrischen Mittelwerte gebildet und als neue Verbraucherklassen definiert.

Aus dieser neu entstandenen Matrix wird wiederum die Kovarianzmatrix gebildet. Sind jetzt weiterhin Korrelationskoeffizienten über dem festgelegten Schwellenwert, so wird die Mittelung dieser Paare und Bildung einer neuen Matrix erneut vorgenommen. Dies wird iterativ so oft wiederholt, bis die Kovarianzmatrix frei von Korrelationskoeffizienten oberhalb des Schwellenwertes ist. Die resultierende Verbrauchermatrix weist dann die Verbraucherspektren der die Verbraucher umfassenden Verbraucherklassen auf.

Auch hier ist ein analoges Vorgehen bei Verwendung zeitlicher Signale möglich.

Die Zusammenlegung der Klassen stellt keinen Nachteil dar. Ziel des Verfahrens ist es, die Oberschwingungen erzeugenden Verbraucher in einem elektrischen Netz zu identifizieren und deren Beitrag zur Gesamtverzerrung des Stromverlaufs in einem elektrischen Netz zu berechnen. Wenn Verbraucher ein sehr ähnliches Verbraucherspektrum aufweisen, so verursachen sie auch ähnliche Störungen im elektrischen Netz. Somit ist eine aus der Zusammenlegung einzelner Verbraucher geschaffene Verbraucherklasse zur Bestimmung der Rückwirkung auf ein elektrisches Netz repräsentativ für die in der Verbraucherklasse enthaltenen Verbraucher.

### 2.5 Fehlerbetrachtungen und Simulation

Bei Berechnungen, die auf Messwerten beruhen, ist eine Fehlerbetrachtung unumgänglich, um abschätzen, wie plausibel die Ergebnisse sind.

### 2.5.1 Auswertung des Restfehlervektors

Der Restfehlervektor *e* gibt Auskunft darüber, wie weit der Vektor b außerhalb des Unterraumes von *A* liegt (siehe Figur 7). Ist *b* eine physikalische Addition der Spaltenvektoren von *A* und nur mit geringen Messfehlern behaftet, so ist der Fehlervektor *e* sehr klein gegenüber *b* und *p*. Um dieses zu überprüfen, lässt sich die euklidische Norm des Vektors e berechnen, indem das LGS *Ax=p* gelöst, der Ergebnisvektor *x* in *e=b-Ax* eingesetzt und die Norm des Vektors e berechnet wird.

### 2.5.2 Gewichtete Fouriersynthese

Um die Ergebnisse zu kontrollieren, werden die sich aus den Verbraucherspektren ergebenden Zeitverläufe mittels inverser Fouriertransformation synthetisiert und entsprechend der Lösung des LGS überlagert. Dieses entspricht einer umfangreichen Kontrolle der Analyse. Ein mit dem gemessenen Zeitverlauf ähnlicher synthetisierter Zeitverlauf kann nur zustande kommen, wenn die Spaltenvektoren die echte Verbraucherstruktur widerspiegeln und die errechnete Verbraucherverteilung der Verbraucher in dem elektrischen Netz der tatsächlichen Verbraucherverteilung nahe kommt. Die Kontrolle umfasst dabei die gesamte kausale Kette einschließlich von der Messung des Stromsignals des elektrischen Netzes, der Fouriertransformation, der Erfassung der Verbraucher, die Klassifizierung der Verbraucher in Verbraucherklassen und die Lösung des LGS.

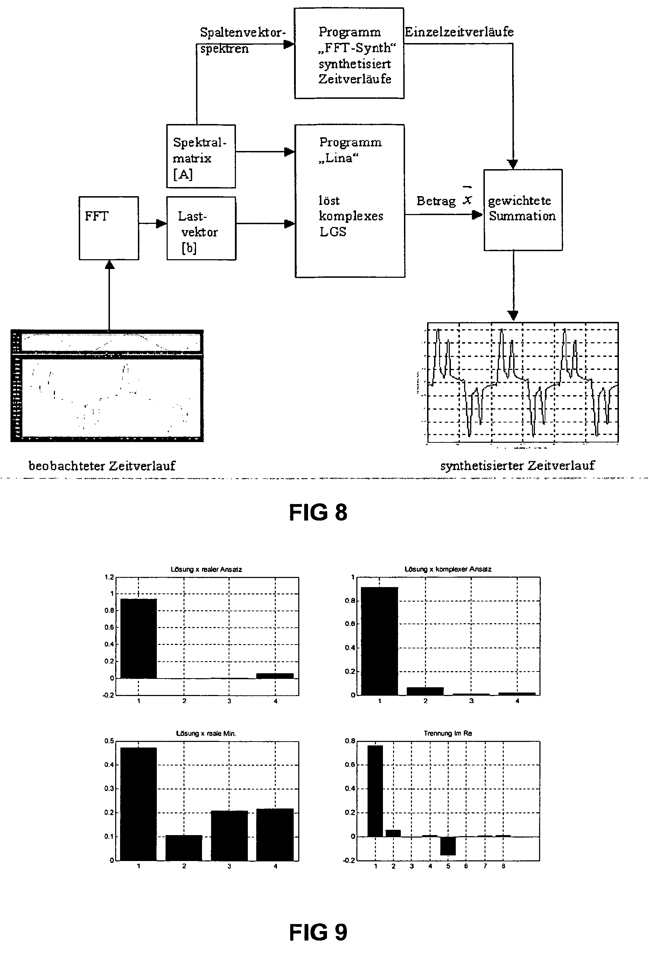

In Figur 8 ist das Schema der Fouriersynthese zu sehen. Die Verläufe der einzelnen Verbraucherklassen werden aus den Verbraucherspektren synthetisiert und entsprechend der ermittelten Verbraucherverteilung überlagert:

$$f(t) = \sum_{j=1}^{m} \sum_{i=1}^{n} x_j a_i \sin(i\omega + \varphi_i) \tag{2-50}$$

Hier bezeichnen $x_j$ die Gewichtung des j-ten Verbraucherspektrums, $\alpha_i$ die die *i*-te Komponente des *j*-ten Verbraucherspektrums dar und *i* die betrachtete Harmonische.

Es kann zweckmäßig sein, nur ungerade Harmonische bei der Aufstellung und Analyse des Netzspektrums zu berücksichtigen. In diesem Fall erfolgt die Summation der Beiträge der Harmonischen bei der Synthese gemäß Gleichung 2-50 ausschließlich über die ungeraden Harmonischen.

Das Netzspektrum $b$ des elektrischen Netzes wird zur Lösung des komplexen LGS benutzt. Die Synthese erfolgt dann ausschließlich aus den in der Verbrauchermatrix hinterlegten Verbraucherspektren und der Verbraucherverteilung $x$ entsprechend der Lösung des LGS.

Ein Einflussfaktor der Qualität der Synthese ist die Phasenlage der einzelnen Harmonischen, deren Zeitverläufe zur Synthese addiert werden. Weist die Verbraucherverteilung $x$ als Lösung des LGS einen imaginären Anteil auf, so liegt ein Phasenfehler in der Analyse vor. Da in die Überlagerung bei der Synthese gemäß Gleichung 2-50 nur der Betrag der Verbraucherverteilung $x$ eingeht, kann die Synthese somit fehlerbehaftet sein.

## 3 Anwendung

In diesem Abschnitt werden Messungen mit einem die Vorrichtung zur Identifikation von Verbrauchern in einem elektrischen Netz ausbildenden Messsystem beschrieben. Diese Messungen dienen der Verifikation der Funktionsweise der Vorrichtung und des erfindungsgemäßen Verfahrens.

In einer ersten Verifikationsmessung wurde das Stromsignal des elektrischen Netzes eines Bürogebäudes mit drei Etagen und ca. 100 typisch ausgestatteten Büros an einem Messpunkt gemessen, die bestehenden Verbraucher am Netz wurden separat erfasst und die einzelnen Verbraucherspektren und das Netzspektrum wurden bestimmt.

Zu diesem Zweck wurden die Verbraucherspektren von PC-Arbeitsplätzen, Kopierern im Standby- oder Betriebszustand, Druckern und Aufzügen gemessen. Aus diesen Verbraucherspektren wurde die Verbrauchermatrix gebildet. Da die Konditionszahl der so gebildeten Matrix groß erschien (im bereich von etwa 80), wurde die Kovarianzmatrix $R$ gebildet (Tab. 3-1), in der sich zwei Korrelationskoeffizienten von über 0.95 fanden. Zur Verbesserung der Konditionszahl der Verbrauchermatrix wurden die Verbraucherspektren mit dem höchsten Korrelationskoeffizienten in einer Verbraucherklasse kombiniert, nämlich das Spektrum der Beleuchtungsanlage und des Kopierers im Betriebszustand. Die neu gebildete, in ihrer Größe um eine Spalte reduzierte Verbrauchermatrix wies eine deutlich geringere Konditionszahl (im Bereich von 20) auf.

Durch die Bildung der Kovarianzmatrix der Verbrauchermatrix werden die neuen Ausprägungen der linearen Abhängigkeit der die Verbraucherspektren darstellenden Spaltenvektoren deutlich (siehe Tabelle 3-2). Die neu gebildete Kovarianzmatrix weist keinen Korrelationskoeffizienten größer als 0.95 auf. Die Verbesserung der Konditionierung kann sich auf einzelne Korrelationskoeffizienten möglicherweise aber negativ auswirken, wie beispielsweise durch den vergrößerten Korrelationskoeffizienten zwischen Beleuchtung und Kopierer im Standby-Zustand (vorher 0.915 (Tabelle 3-1), jetzt 0.938 (Tabelle 3-2)) erkennbar ist. Daher kann ein iteratives Vorgehen bei der Aufstellung der Verbrauchermatrix zur Optimierung der Kovarianzmatrix von Vorteil sein.

**Tabelle 3-1 Kovarianzmatrix der Verbraucherstrucktur M516**

| Verbraucher | Beleuchtung | PC-Plätze (alt) | PC-Plätze (neu) | Kopierer Standby | Kopierer in Betrieb |
|---|---|---|---|---|---|
| Beleuchtung | 1 | 0,50415 | 0,81882 | 0,91457 | 0,97463 |
| PC-Platz (alt) | - | 1 | 0,85688 | 0,57222 | 0,62842 |
| PC-Platz (neu) | - | - | 1 | 0,87909 | 0,91279 |
| Kopierer Standby | - | - | - | 1 | 0,96068 |

**Tabelle 3-2 Kovarianzmatrix der überarbeiteten Verbrauchermatrix. Klasse Linear=(Beleuchtung+Kopierer)**

| Verbraucher | Linear | PC-Plätze (alt) | PC-Plätze (neu) | Kopierer in Standby |
|---|---|---|---|---|
| Linear | 1 | 0,56869 | 0,8703 | 0,93893 |
| PC-Plätze (alt) | - | 1 | 0,85688 | 0,57222 |
| PC-Plätze (neu) | - | - | 1 | 0,87909 |

Gleichung 3-1 zeigt das Schema des Gleichungssystems und Figur 9 die identifizierte Verbraucherverteilung der Verbraucher in dem elektrischen Netz des Gebäudes. Das Ergebnis zeigt einen linearen Anteil von 90% (Verbraucher 1), ca. 5% beträgt der Anteil älterer PC-Arbeitsplätze (Verbraucher 2), während sich die restlichen 5% sich auf die Anteile von Kopierern (Verbraucher 4) und modernen PC-Arbeitsplätzen (Verbraucher 3) verteilen.

$$\underbrace{\begin{pmatrix} Spaltenvektor1 & Spaltenvektor2 & Spaltenvektor3 & Spaltenvektor4 \\ Beleuchtung & ältere\_PC- & Kopierer & mod\,erne \\ bestehend & Arbeitsplätze & im & PC-Plätze \\ aus\_konv.LsL & . & S\tan dbybetrieb & \end{pmatrix}}_{VerbrauchermatrixA4} \begin{pmatrix} x_1 \\ x_2 \\ x_3 \\ x_4 \end{pmatrix} = \underbrace{\begin{pmatrix} MessVekor\_b \\ von\_der \\ Haupverteilung \\ Keller\_M516\_13.5.2005 \end{pmatrix}}_{Messvektor\_b} \qquad (3\text{-}1)$$

Der komplexe Ansatz spiegelt die tatsächliche Verbraucherverteilung der Verbraucher in dem elektrischen Netz realistisch wider und ist daher zu bevorzugen. Die anderen Ansätze erweisen anhand der Ergebnisse in Figur 9 sich als deutlich ungenauer.

Im Folgenden werden Messungen an einem elektrischen Netz mit weitgehend unbekannter Verbraucherstruktur beschrieben.

Da an einem elektrischen Netz in der Regel eine Vielzahl von unterschiedlichen Verbrauchern beteiligt sind und es nicht möglich ist, alle unterschiedlichen Verbraucher in der Verbrauchermatrix zu berücksichtigen, ist eine Einteilung der Verbraucher vorab in Verbraucherklassen notwendig.

Dieser Messung zugrunde gelegt wurde eine beispielhafte Einteilung in folgende Verbraucherklassen, die in dem elektrischen Netz identifiziert werden sollten:

1. lineare Verbraucher ohne Phasenverschiebung (rein ohmsche Verbraucher)
2. lineare Verbraucher mit induktivem Verhalten wie Motoren und Drosseln
3. Verbraucher mit einem B2-Gleichrichter-Verhalten, z.B. PCs ohne Power Factor Correction (PFC), Sparlampen, Netzteile von Druckern und andere Kleingeräte
4. Verbraucher mit einem B6-Gleichrichter-Verhalten mit starker Belastung, z.B. Frequenzumrichter im Nennlastbetrieb
5. gesteuerte B6-Stromrichter, z.B. Frequenzumrichter mit Leistungsreglung.

Die typischen Verbraucherspektren dieser Verbraucher wurden zu einer Verbrauchermatrix *A* zusammengesetzt. Das lineare Gleichungssystem gemäß Gleichung 2-9 wurde dann für verschiedene gemessene Netzspektren gelöst und somit die Anteile der Verbraucher in dem elektrischen Netz bestimmt.

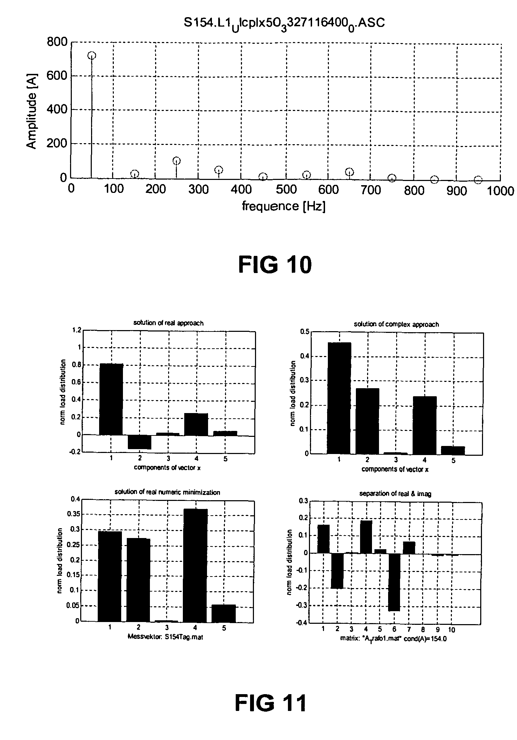

Das untersuchte elektrische Netz befand sich in einem fünfstöckigen Gebäude mit hauptsächlich Laboreinrichtungen. Die Verbraucher in diesem Gebäude waren im Wesentlichen Beleuchtungsanlagen, Lüftungsanlagen, Trockenschränke, Laborgeräte und PCs, wobei die genaue Verbraucherverteilung und Art der Verbraucher in dem Gebäude unbekannt war. Das Stromsignal des elektrischen Netzes des Gebäudes wurde an einem Messpunkt, der dem Verbindungspunkt des elektrischen Netzes des Gebäudes mit einem externen Energieversorgungsnetz angeordnet war, gemessen. Das gemessene Netzspektrum ist in Figur 10 in absolut gemessenen Werten dargestellt.

Figur 11 zeigt die Lösungen des linearen Gleichungssystems. Aus der Lösung gemäß dem komplexen Ansatz geht hervor, dass von den Verbrauchern im elektrischen Netz des Gebäudes 45% auf rein ohmsche Verbraucher (Klasse 1 gemäß obiger Liste), ca. 25% auf lineare Verbraucher mit induktivem Anteil (Klasse 2) und etwa 23% auf Verbraucher mit einem B6-Gleichrichter-Verhalten entfallen.

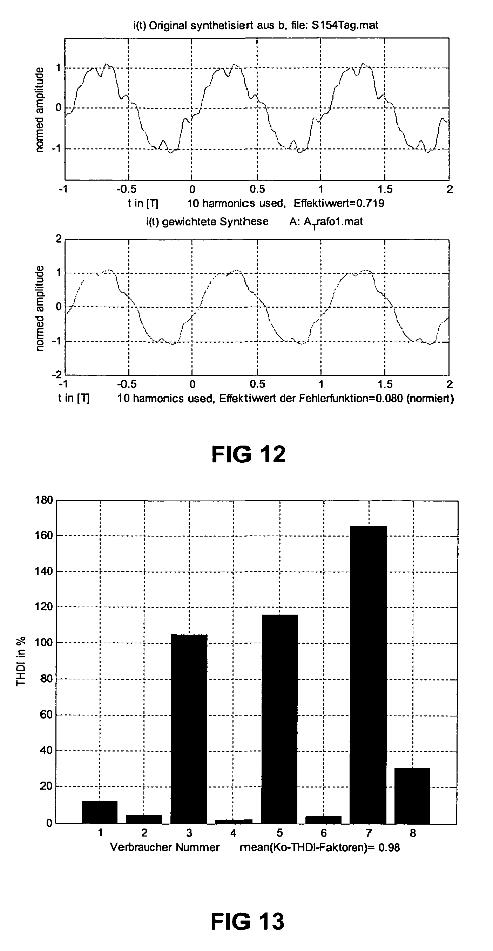

Figur 12 zeigt das aus den Spektren der Verbrauchermatrix und der errechneten Verbraucherverteilung der Verbraucher in dem elektrischen Netz (gemäß komplexem Ansatz) synthetisierte zeitliche Stromsignal (unten) und das am Messpunkt des elektrischen Netzes gemessene Stromsignal (oben). Der Effektivwert des normierten Differenzsignals, das durch die Differenz zwischen synthetisiertem und gemessenem Stromsignal gebildet ist, beträgt 0,08, während der Effektivwert des gemessenen, normierten Stromsignals 0.72 beträgt. Dies zeigt, dass sowohl die eingesetzte Verbrauchermatrix, die Messung und die Analyse die Verbraucherverteilung der Verbraucher in dem elektrischen Netz hinreichend exakt erfasst bzw. durchgeführt wurden.

**4 Zusammenschaltung von Verbrauchern**

Die durch Verbraucher verursachten Oberschwingungsanteile im Strom eines elektrischen Netzes belasten das elektrische Netz stark. Mit Hilfe der Vorrichtung zur Identifizierung von Verbrauchern in einem elektrischen Netz kann der Oberschwingungsgehalt des Stromes und der Spannung aufgezeichnet, Zeiten mit besonders hoher Belastung detektiert und die Verbraucher in dem elektrischen Netz identifiziert werden. Auf diese Weise können Störquellen ermittelt und diese Kenntnis dazu verwandt werden, die Oberschwingungsspitzen zu verringern, beispielsweise indem Betriebszeiten geändert oder Verbraucher auf bestimmte Weise verschaltet werden.

**4.1 Statistische Betrachtung von Überlagerungen verschiedener Quellen**

**Überlagerung von Harmonischen und der Einfluss auf die Verzerrung durch**

**Oberschwingungen** Durch die Zusammenschaltung von mehreren Oberschwingungserzeugern kann es zur konstruktiven (bei gleicher Phase) oder destruktiven Überlagerung (bei entgegengesetzter Phase) von Harmonischen kommen. Hier ist es denkbar, entweder einzelne Harmonische zu betrachten oder die durch die Gesamtheit der Harmonischen hervorgerufene Verzerrung des aufgenommenen Stromverlaufs eines elektrischen Netzes (Total Harmonic Distortion des Stromverlaufs: *THD(I)*) zu betrachten.

Die Total Harmonic Distortion des n-ten Verbrauchers (*THD(I)$_n$*) ist dabei definiert als

$$THD(I)_n = \frac{\sqrt{\sum_{i=2}^{50} I_{in}^{\ 2}}}{I_{1rms}} \tag{4-1}$$

wobei $I_{in}$ die Stromamplituden der *i*-ten Harmonischen des *n*-ten Verbrauchers bezeichnen und $I_{1rms}$ den Effektivwert der Grundschwingung darstellt.

Statistischer Ansatz Von Windkraftanlagen in Windparks ist bekannt, dass sich die Verzerrung des Stromverlaufs *THD(I)* abhängig von der Anzahl der betriebenen Anlagen ergibt. Dabei stellte wurde empirisch folgender Zusammenhang festgestellt:

$$THD(I)_G = \frac{THD(I)_n}{\sqrt{n}} \tag{4-2}$$

Für Frequenzumrichteranlagen gilt für Harmonische *n<7*:

$$I_n = \sum_{i=1}^{m} I_{n_i} \tag{4-3}$$

und für Harmonische *n>7*:

$$I_n = \sqrt{\sum_{i=1}^{m} I_{n_i}^{\ 2}} \tag{4-4}$$

Solche Richtwerte sind wichtige Größen bei der Planung und Auslegung von Anlagen mit vielen Verbrauchern und anderen potentiellen Oberschwingungserzeugern.

**4.2 Deterministische Betrachtung von Überlagerungen der Antwort unterschiedlicher Verbraucher**

Zur Untersuchung der Überlagerung verschiedener Verbraucherspektren und deren Auswirkung auf die Verzerrung des Stromverlaufs in einem elektrischen Netz werden der *THD(I)* einer Überlagerung zweier Verbraucher, die Verzerrungen verursachende Störquellen darstellen, mit dem mittleren THD(I) dieser Verbraucher verglichen und in einem Koeffizienten dargestellt.

Dieser Koeffizient wird hier in Anlehnung an die Kovarianzauswertung "Ko-THDI-Faktor" genannt. Wird eine vollständige Verbrauchermatrix ausgewertet, entsteht eine "KoTHDI-Matrix", deren Einträge eine jeweilige Abschwächung oder Verstärkung des Oberschwingungsgehaltes bei Zusammenschaltung der jeweils betroffenen Verbraucher anzeigen. Die KoTHDI-Matrix ist symmetrisch und weist folgende Gestalt auf:

$$R_{THD(I)} = \begin{pmatrix} 1 & r_{THD(I)_{12}} & \cdot & r_{THD(I)_{1n}} \\ r_{THD(I)_{21}} & 1 & & \cdot \\ \cdot & \cdot & \cdot & \cdot \\ r_{THD(I)_{m1}} & \cdot & \cdot & 1 \end{pmatrix} \qquad (4\text{-}5)$$

Die Ko-THDI-Faktoren lassen sich auf folgende Weise berechnen:

$$r_{THD(I)_{ij}} = \frac{THD(I_i + I_j)}{E(THD(I_i) + THD(I_j))} \qquad (4\text{-}6)$$

*E* entspricht hier dem statistischen Erwartungswert. Wie aus Gleichung 4-6 folgt, ist jeder Ko-THDI-Faktor normiert und in der Größenordnung von 1. Ein Wert kleiner 1 repräsentiert eine überwiegende Auslöschung von Oberschwingungen, während ein Wert größer 1 eine Verstärkung durch konstruktive Überlagerungen der Harmonischen bewirkt.

Beispielsweise ist es bei Überlegungen über Auslöschungen oder Verstärkungen nahe liegend, Verbraucher mit einem B2-Gleichrichter-Verhalten und Verbraucher mit einem B6-Gleichrichter-Verhalten B6 zu kombinieren, deren Spektren jeweils sehr ausgeprägte fünfte und siebente Harmonische aufweisen, die gegenphasig zueinander stehen und sich somit zumindest teilweise auslöschen und eine Verringerung des *THD(I)* bewirken.

Figur 13 zeigt gemessene *THD(I)*-Werte von acht unterschiedlichen Verbrauchern. Die Zuordnung der Verbraucher kann aus der Tabelle 4-1 entnommen werden, die die KoTHDI-Matrix der acht unterschiedlichen Verbraucher angibt. Die *THD(I)*-Werte zeigen eine vergleichsweise starke Abweichung voneinander, die von wenigen Prozent beim Verbraucher "T5" (eine Leuchtstoffröhre) bis zu Werten größer als 160% bei dem Verbraucher "Laptop" reicht.

**Tabelle 4-1 Ko-THDI-Matrix der Verbrauchermatrix aus dem Labor**

| Verbraucher | T8 | T5 | Sparlampe | Glühlampe | FU | Motor | Laptop | Monitor |
|---|---|---|---|---|---|---|---|---|
| T8 | 1 | 1,0511 | 0,94596 | 0,97613 | 1,0733 | 1,3244 | 1,1949 | 1,0698 |
| T5 | 1,0511 | 1 | 1,1422 | 0,85927 | 0,96899 | 0,75796 | 0,97609 | 0,9709 |
| Sparlampe | 0,94596 | 1,1422 | 1 | 1,0858 | 0,84085 | 1,418 | 0,9414 | 1,1922 |
| Glühlampe | 0,97613 | 0,85927 | 1,0858 | 1 | 0,99192 | 0,47613 | 0,98352 | 0,9829 |
| FU | 1,0733 | 0,96899 | 0,84085 | 0,99192 | 1 | 1,0305 | 0,5475 | 0,8159 |
| Motor | 1,3244 | 0,75796 | 1,418 | 0,47613 | 1,0305 | 1 | 1,0235 | 0,91218 |
| Laptop | 1,1949 | 0,97609 | 0,9414 | 0,98352 | 0,5475 | 1,0235 | 1 | 0,89966 |
| Monitor | 1,0698 | 0,9709 | 1,1922 | 0,9829 | 0,8159 | 0,91218 | 0,89966 | 1 |

Aus der Tabelle 4-1 folgt, dass bei Verschaltung von einem durch einen Frequenzumrichter (FU) gebildeten Verbraucher und einem als Laptop ausgebildeten Verbraucher eine erhebliche Abschwächung des *THD(I)* erreichbar ist. Die Auslöschung in den Harmonischen ist in diesem Fall signifikant, so dass das *THD(I)* um ca. 45% unter dem Mittel der beiden einzelnen liegt (dieses ist angezeigt durch den Ko-THDI-Faktor).

Die Einbeziehung der KoTHDI-Matrix kann bei einer Planung eines elektrischen Netzes behilflich sein. So könnte aus einem Pool von potentiellen Verbrauchern für jeden Verknüpfungspunkt die günstigsten Verschaltungskombinationen ermittelt werden. Wie man an der Matrix in Tabelle 4-1 erkennen kann, lässt sich prinzipiell eine signifikante Abschwächung der Verzerrung in einem elektrischen Netz durch geeignete Verschaltung von Verbrauchern erreichen.

**Bezugszeichenliste**

| | |
|---|---|
| 1 | Elektrisches Netz |
| 2a, 2b | Verbraucher |
| 3 | Messvorrichtung zur Messung des Stromsignals des elektrischen Netzes |
| 4 | Messvorrichtung zur Erfassung der Verbraucherspektren |
| 4' | Analyseeinrichtung |
| 5 | Speichermedium |
| 6 | Datenanalyseeinrichtung |
| 61 | Mittel zur Durchführung einer Fouriertransformation |
| 62, 63, 64 | Mittel zur Generierung des Modells |
| 7 | Ausgabevorrichtung |
| 8 | Kompensationsvorrichtung |
| E1-E4 | Verbraucher |
| S1-S3 | Schalter |
| MP8- MP11 | Messpunkte |

**Patentansprüche**

1. Vorrichtung zur Identifizierung von Verbrauchern (2a, 2b) in einem elektrischen Netz (1) mit zeitlich veränderlichen Strömen, mit

    - einer Messvorrichtung (3) zur Messung mindestens eines Stromsignals an mindestens einem Messpunkt (MP8) des elektrischen Netzes (1),
    - einem Speichermedium (5), in dem mindestens ein vorab erfasstes Verbrauchersignal gespeichert ist,
    - einer Datenanalyseeinrichtung (6), die

        - das mindestens eine gemessene Stromsignal in ein Netzsignal umwandelt,
        - automatisch ein Modell generiert, in dem das Netzsignal mit mindestens einem in dem Speichermedium vorab gespeicherten Verbrauchersignal mindestens eines Verbrauchers (2a, 2b) verknüpfbar ist,
        - automatisch das Modell zur Bestimmung mindestens einer Verbraucherverteilung der Verbraucher (2a, 2b) im elektrischen Netz (1) analysiert, und

    - einer Ausgabevorrichtung (7) für die mindestens eine Verbraucherverteilung.

2. Vorrichtung nach Anspruch 1, **dadurch gekennzeichnet, dass** das gemessene Stromsignal ein zeitliches Signal ist.

3. Vorrichtung nach einem der Ansprüche 1 oder 2, **dadurch gekennzeichnet, dass** das Netzsignal des elektrischen Netzes(1) und die in dem Speichermedium (5) gespeicherten Verbrauchersignale zeitliche Signale oder Frequenzspektren darstellen.

4. Vorrichtung nach Anspruch 3, **dadurch gekennzeichnet, dass** die Datenanalyseeinrichtung (6) Mittel (61) aufweist, mittels derer ein das Netzsignal darstellendes Netzspektrum aus dem gemessenen Stromsignal des elektrischen Netzes (1) ermittelbar ist.

5. Vorrichtung nach Anspruch 4, **dadurch gekennzeichnet, dass** die Datenanalyseeinrichtung (6) zur Bestimmung des Netzspektrums Mittel (61) zur Durchführung einer Fouriertransformation des gemessenen Stromsignals des elektrischen Netzes (1) aufweist.

6. Vorrichtung nach mindestens einem der Ansprüche 3 bis 5, **dadurch gekennzeichnet, dass** in dem Speichermedium (5) mindestens ein ein Verbrauchersignal darstellendes Verbraucherspektrum oder mindestens ein zeitliches Verbrauchersignal gespeichert ist.

7. Vorrichtung nach mindestens einem der Ansprüche 3 bis 6, **dadurch gekennzeichnet, dass** die Datenanalyseeinrichtung (6) Mittel (62, 63, 64) zur Generierung des Modells vorsieht, mittels derer das mindestens eine Verbraucherspektrum oder das mindestens eine zeitliche Verbrauchersignal und das Netzspektrum oder das zeitliche Netzsignal in einem Gleichungssystem verknüpfbar sind.

8. Vorrichtung nach einem der vorangehenden Ansprüche, **gekennzeichnet durch** eine Messvorrichtung (4) zur Erfassung mindestens eines Verbrauchersignals mindestens eines Verbrauchers (2a, 2b), die mit dem Speichermedium (5) zur Speicherung des mindestens einen Verbrauchersignals verbindbar ist.

9. Vorrichtung nach Anspruch 8, **dadurch gekennzeichnet, dass** die Messvorrichtung (4) zur Erfassung des mindestens einen Verbrauchersignals Mittel aufweist, mittels derer das Stromsignal des mindestes einen Verbrauchers (2a, 2b) messbar ist.

10. Vorrichtung nach Anspruch 9, **dadurch gekennzeichnet, dass** die Messvorrichtung (4) zur Erfassung des mindestens einen Verbrauchersignals Mittel zur Durchführung einer Fouriertransformation des gemessenen Stromsignals des mindestens einen Verbrauchers (2a, 2b) aufweist, um ein das Verbrauchersignal darstellendes Verbraucherspektrum zu bestimmen.

11. Vorrichtung nach einem der Ansprüche 8 bis 10, **dadurch gekennzeichnet, dass** die Messvorrichtung (4) zur Erfassung des mindestens einen Verbrauchersignals Mittel aufweist, mittels derer Verbraucher (2a, 2b) anhand der erfassten Verbrauchersignale in Verbraucherklassen einteilbar sind.

12. Vorrichtung nach einem der Ansprüche 8 bis 11, **dadurch gekennzeichnet, dass** die Messvorrichtung (4) zur Erfassung mindestens eines Verbrauchersignals ein mobiles Messgerät zur Messung des Stromsignals eines Verbrauchers (2a, 2b) aufweist.

13. Vorrichtung nach mindestens einem der vorangehenden Ansprüche, **dadurch gekennzeichnet, dass** die Vorrichtung (3 - 7) zur Identifizierung von Verbrauchern (2a, 2b) in einem elektrischen Netz (1) fest mit dem elektrischen Netz (1) verbunden ist.

14. Vorrichtung nach mindestens einem der vorangehenden Ansprüche, **dadurch gekennzeichnet, dass** die Vorrichtung (3 - 7) zur Identifizierung von Verbrauchern (2a, 2b) in einem elektrischen Netz (1) in ein Messgerät integriert ist und Anschlüsse zur Verbindung mit mindestens einem elektrischen Verbraucher (2a, 2b) und einem elektrischen Netz (1) aufweist.

15. Vorrichtung nach mindestens einem der vorangehenden Ansprüche, **gekennzeichnet durch** eine Kompensationsvorrichtung (8), die zur Kompensation einer Verzerrung der Ströme und Spannungen in dem elektrischen Netz (1) mit der Datenanalyseeinrichtung (6) so zusammenwirkt, dass die Ströme und Spannungen des elektrischen Netzes (1) in gewünschter Weise angepasst werden.

16. Vorrichtung nach mindestens einem der vorangehenden Ansprüche, **dadurch gekennzeichnet, dass** das elektrische Netz ein Energieversorgungsnetz (1) darstellt, wobei die Vorrichtung (3 - 7) die Verbraucherverteilung von Verbrauchern (2a, 2b) in dem Energieversorgungsnetz (1) bestimmt und abhängig von der Verbraucherverteilung der Verbraucher (2a, 2b) der Strom und die Spannung, die an einem Einspeisungspunkt des Energieversorgungsnetzes (1) anliegen, variiert werden.

17. Vorrichtung nach mindestens einem der vorangehenden Ansprüche, **dadurch gekennzeichnet, dass** das elektrische Netz (1) Teil einer elektrische Verbraucher (2a, 2b) aufweisenden Anlage ist, wobei mittels der Vorrichtung (3 - 7) die elektrischen Verbraucher (2a, 2b) der Anlage überwachbar und / oder steuerbar sind.

18. Verfahren zum Betreiben der Vorrichtung (3 - 7) nach einem der Ansprüche 1 bis 17, mit folgenden Schritten:

- Messung mindestens eines Stromsignals eines elektrischen Netzes (1) an mindestens einem Messpunkt (MP8),
- Bestimmung eines Netzsignals aus dem mindestens einen gemessenen Stromsignal des elektrischen Netzes (1),
- automatische Generierung eines Modells, in dem das Netzsignal und mindestens ein vorab erfasstes Verbrauchersignal mindestens eines Verbrauchers (2a, 2b) miteinander verknüpft sind,
- automatische Analyse des Modells zur Identifizierung der Verbraucher (2a, 2b) im elektrischen Netz (1),
- Speicherung und / oder Ausgabe einer diskreten Verbraucherverteilung im elektrischen Netz (1).

**19.** Verfahren nach Anspruch 18, **dadurch gekennzeichnet, dass** das Verbrauchersignal des mindestens einen Verbrauchers (2a, 2b) einen Vektor darstellt, der zur Generierung des Modells in einer Verbrauchermatrix angeordnet wird.

**20.** Verfahren nach Anspruch 19, **dadurch gekennzeichnet, dass** zur Generierung des Modells aus der Verbrauchermatrix und einem gemessenen Netzsignal ein Gleichungssystem gebildet wird, das zur Identifikation der Verbraucher (2a, 2b) im elektrischen Netz (1) analysiert wird.

**21.** Verfahren nach mindestens einem der Ansprüche 18 bis 20, **dadurch gekennzeichnet, dass** vorab das Verbrauchersignal mindestens eines Verbrauchers (2a, 2b) erfasst und in einem Speichermedium (5) gespeichert wird.

**22.** Verfahren nach Anspruch 21, **dadurch gekennzeichnet, dass** zur Bestimmung des Verbrauchersignals des mindestens einen Verbrauchers (2a, 2b) das Stromsignal des mindestens einen Verbrauchers (2a, 2b) vorab gesondert gemessen wird.

**23.** Verfahren nach einem der Ansprüche 18 bis 22, **dadurch gekennzeichnet, dass** zur Erfassung des mindestens einen Verbrauchersignals des mindestens einen Verbrauchers (2a, 2b) unterschiedliche Netzsignale zu unterschiedlichen Zeitpunkten erfasst werden und aus den unterschiedlichen, erfassten Netzsignalen das mindestens eine Verbrauchsignal des mindestens einen Verbrauchers (2a, 2b) bestimmt wird.

**24.** Verfahren nach Anspruch 23, **dadurch gekennzeichnet, dass** das mindestens eine Verbrauchersignal des mindestens einen Verbrauchers (2a, 2b) durch eine Eigenwertanalyse oder Singulärwertzerlegung der in einer Matrix angeordneten, unterschiedlichen, erfassten Netzsignale bestimmt wird.

**25.** Verfahren nach mindestens einem der Ansprüche 23 oder 24, **dadurch gekennzeichnet, dass** die Erfassung des mindestens einen Verbrauchersignals wiederholt durchgeführt wird und das erfasste Verbrauchersignal iterativ angepasst und / oder neu gespeichert wird.

**26.** Verfahren nach mindestens einem der Ansprüche 20 bis 25, **dadurch gekennzeichnet, dass** Verbraucher (2a, 2b) mit ähnlichen Verbrauchersignalen einer Verbraucherklasse zugeordnet werden, wobei sich das Verbrauchersignal der Verbraucherklasse aus den Verbrauchersignalen der in der Verbraucherklasse zusammengefassten Verbraucher (2a, 2b) ergibt.

**27.** Verfahren nach Anspruch 26, **dadurch gekennzeichnet, dass** die ähnlichen Verbrauchersignale einen normierten Korrelationskoeffizienten größer als 0.9, insbesondere 0.95 aufweisen.

**28.** Verfahren nach Anspruch 26 oder 27, **dadurch gekennzeichnet, dass** die Einteilung der Verbraucher (2a, 2b) in Verbraucherklassen iterativ erfolgt und adaptiv durch zeitlich gestaffelte Messungen angepasst wird.

**29.** Verfahren nach mindestens einem der Ansprüche 20 bis 28, **dadurch gekennzeichnet, dass** das Verbrauchersignal des mindestens einen Verbrauchers (2a, 2b) ein Verbraucherspektrum und das Netzsignal des elektrischen Netzes (1) ein Netzspektrum darstellen, wobei im Verbraucherspektrum und im Netzspektrum die Amplituden der harmonischen Oberschwingen des Stromsignals des mindestens einen Verbrauchers (2a, 2b) bzw. des elektrischen Netzes (1) gespeichert sind.

**30.** Verfahren nach Anspruch 29, **dadurch gekennzeichnet, dass** in dem Modell nur die ungeraden harmonischen Oberschwingungen des mindestens einen Verbraucherspektrums und des Netzspektrums berücksichtigt werden.

**31.** Verfahren nach Anspruch 30, **dadurch gekennzeichnet, dass** abhängig von der Anzahl der Verbraucher (2a, 2b) und der Anzahl der in den Verbraucherspektren und dem Netzspektrum erfassten harmonischen Oberschwingungen sich ein unterbestimmtes, ein bestimmtes oder ein überbestimmtes Gleichungssystem ergibt.

**FIG 1A**

**FIG 1B**

**FIG 1C**

```
┌─────────────────────────────────────────────────────┐
│  Messung eines Stromsignals eines elektrischen Netzes │
│  an einem Messpunkt des elektrischen Netzes           │
└─────────────────────────────────────────────────────┘
                          │
                          ▼
┌─────────────────────────────────────────────────────┐
│  Bestimmung eines Netzsignals aus dem gemessenen      │
│  Stromsignal des elektrischen Netzes                  │
└─────────────────────────────────────────────────────┘
                          │
                          ▼
┌─────────────────────────────────────────────────────┐
│  automatische Generierung eines Modells, in dem das   │
│  Netzsignal und vorab erfasste Verbrauchersignale von │
│  Verbrauchern miteinander verknüpft sind              │
└─────────────────────────────────────────────────────┘
                          │
                          ▼
┌─────────────────────────────────────────────────────┐
│  automatische  Analyse des Modells zur Identifizierung │
│  der Verbraucher im elektrischen Netz                 │
└─────────────────────────────────────────────────────┘
                          │
                          ▼
┌─────────────────────────────────────────────────────┐
│  Speicherung und / oder Ausgabe der diskreten         │
│  Verbraucherverteilung der Verbraucher im elektrischen │
│  Netz                                                 │
└─────────────────────────────────────────────────────┘
```

# FIG 1D

**FIG 2**

**FIG 3**

**FIG 4A**

**FIG 4B**

**FIG 5A**

**FIG 5B**

**FIG 6**

**FIG 7**

Spaltenvektor-spektren

Programm „FFT-Synth" synthetisiert Zeitverläufe

Einzelzeitverläufe

Spektral-matrix [A]

Programm „Lina"

löst komplexes LGS

Betrag $\overline{x}$

gewichtete Summation

FFT

Last-vektor [b]

beobachteter Zeitverlauf

synthetisierter Zeitverlauf

# FIG 8

Lösung x realer Ansatz

Lösung x komplexer Ansatz

Lösung x reale Min.

Trennung Im Re

# FIG 9

$S154.L1_U Icplx5O_3 327116400_0.ASC$

**FIG 10**

**FIG 11**

i(t) Original synthetisiert aus b, file: S154Tag.mat

t in [T]    10 harmonics used,  Effektiwert=0.719

i(t) gewichtete Synthese    A: A$_T$rafo1.mat

t in [T]    10 harmonics used, Effektiwert der Fehlerfunktion=0.080 (normiert)

## FIG 12

mean(Ko-THDI-Faktoren)= 0.98

Verbraucher Nummer

## FIG 13

**Europäisches Patentamt**

**EUROPÄISCHER RECHERCHENBERICHT**

Nummer der Anmeldung

EP 06 09 0173

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | VAN NIEKERK C R ET AL: "Identification of types of distortion sources in power systems by applying neural networks" 2002 IEEE AFRICON 6TH. AFRICON CONFERENCE IN AFRICA. UNIVERSITY OF PRETORIA, GEORGE, SOUTH AFRICA, OCT. 2 - 4, 2002, IEEE AFRICON CONFERENCE IN AFRICA, NEW YORK, NY : IEEE, US, Bd. VOL. 1 OF 2. CONF. 6, 2. Oktober 2002 (2002-10-02), Seiten 829-834, XP010622919 ISBN: 0-7803-7570-X | 1-9, 11-14, 17,18, 21-23, 25-30 | INV. G01R19/25 G01R23/20 |
| Y | * das ganze Dokument * | 15,16 | |
| | ----- | | |
| X | UMEH K ET AL: "Intelligent System for Identification of Harmonics Originating from Single Phase Nonlinear Loads" SOUTHEASTCON, 2005. PROCEEDINGS. IEEE FT. LAUDERDALE, FLORIDA, USA APRIL 8-10, 2005, PISCATAWAY, NJ, USA,IEEE, 8. April 2005 (2005-04-08), Seiten 137-142, XP010789714 ISBN: 0-7803-8865-8 * das ganze Dokument * | 1-11,17, 18,21, 22,28 | RECHERCHIERTE SACHGEBIETE (IPC) G01R H02J |
| | ----- | | |
| X | BAOSHU LI ET AL: "The Research of Electric Appliance Running Status Detecting Based on DSP" TRANSMISSION AND DISTRIBUTION CONFERENCE AND EXHIBITION: ASIA AND PACIFIC, 2005 IEEE/PES DALIAN, CHINA 15-18 AUG. 2005, PISCATAWAY, NJ, USA,IEEE, 15. August 2005 (2005-08-15), Seiten 1-4, XP010885921 ISBN: 0-7803-9114-4 * das ganze Dokument * | 1-6, 8-11,17, 18,21, 22,28 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| Den Haag | 10. Januar 2007 | Koll, Hermann |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

# EUROPÄISCHER RECHERCHENBERICHT

**Nummer der Anmeldung**

EP 06 09 0173

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | RUKONUZZAMAN M ET AL: "DSP control shunt APF with harmonic extraction by adaptive neural network" CONFERENCE RECORD OF THE 2003 IEEE INDUSTRY APPLICATIONS CONFERENCE. 38TH. IAS ANNUAL MEETING . SALT LAKE CITY, UT, OCT. 12 - 16, 2003, CONFERENCE RECORD OF THE IEEE INDUSTRY APPLICATIONS CONFERENCE. IAS ANNUAL MEETING, NEW YORK, NY : IEEE, US, Bd. VOL. 3 OF 3. CONF. 38, 12. Oktober 2003 (2003-10-12), Seiten 1215-1221, XP010675992 ISBN: 0-7803-7883-0 * das ganze Dokument * ----- | 15,16 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 10. Januar 2007 | Koll, Hermann |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)